# EUROPEAN PATENT APPLICATION

(11) **EP 4 394 872 A1**
(43) Date of publication of application: **03.07.2024**
(21) Application number: 23219501.6
(22) Date of filing: 21.12.2023
(51) Int. Cl.: H01L 25/075, H01L 25/16

(54) **DISPLAY DEVICE**

(30) Priority: 26.12.2022 KR 20220184822
(71) Applicant: Samsung Display Co., Ltd., Yongin-si, Gyeonggi-do 17113 (KR)
(72) Inventor: KIM, Jin Taek, 17113 Yongin-si (KR); LEE, Hyun Wook, 17113 Yongin-si (KR)
(74) Representative: Taor, Simon Edward William

(57) **Abstract**

A display device may include: a pixel circuit layer including a first transistor and a first auxiliary layer; and a display element layer on the pixel circuit layer, and including at least one light emitting element. The display element layer may include: a first pixel electrode electrically connected to a first end of the light emitting element; and a second pixel electrode electrically connected to a second end of the light emitting element. The first transistor may include: a semiconductor pattern; a first gate insulating layer on the semiconductor pattern; a gate electrode on the first gate insulating layer; and a first transistor electrode and a second transistor electrode connected to the semiconductor pattern. The first transistor electrode may be connected to the second pixel electrode by the first auxiliary layer. The first auxiliary layer may be between the first and second pixel electrodes.

## Description

### CROSS-REFERENCE TO RELATED APPLICATION

This application claims priority to and the benefit of Korean Patent Application number 10-2022-0184822 filed on December 26, 2022.

### BACKGROUND

### 1. Field

Various embodiments of the present disclosure relate to a display device.

### 2. Description of Related Art

Recently, as interest in information display increases, research and development on display devices have been continuously conducted.

### SUMMARY

One or more embodiments of the present disclosure are directed to a display device capable of reducing or minimizing defects attributable to contact resistance and reactivity between pixel electrodes and pixel circuit elements that are included in the display device.

One or more embodiments of the present disclosure are directed to a display device including the pixel.

However, aspects and features of embodiments of the present disclosure are not limited to the above-described aspects and features, and various modifications are possible without departing from the scope of the present disclosure.

One or more embodiments of the present disclosure may provide a display device including: a pixel circuit layer including a first transistor and a first auxiliary layer; and a display element layer on the pixel circuit layer, and including at least one light emitting element. The display element layer may include: a first pixel electrode electrically connected to a first end of the light emitting element; and a second pixel electrode electrically connected to a second end of the light emitting element. The first transistor may include: a semiconductor pattern; a first gate insulating layer on the semiconductor pattern; a gate electrode on the first gate insulating layer; and a first transistor electrode and a second transistor electrode connected to the semiconductor pattern. The first transistor electrode may be connected to the second pixel electrode by the first auxiliary layer. The first auxiliary layer may be between the first transistor electrode and the second pixel electrode.

In one or more embodiments, the first auxiliary layer may include indium tin oxide (ITO).

In one or more embodiments, the first auxiliary layer may be directly on the first transistor electrode.

In one or more embodiments, the first transistor electrode and the second transistor electrode may include titanium (Ti) and copper (Cu).

In one or more embodiments, the pixel circuit layer may further include: a first bottom metal layer on a substrate, and electrically connected to the second transistor electrode; a buffer layer covering the first bottom metal layer; and a conductive pattern at the same layer as the gate electrode, and electrically connected to the first bottom metal layer. The display element layer may further include: a first alignment electrode under the first pixel electrode; and a second alignment electrode under the second pixel electrode. One alignment electrode from among the first alignment electrode and the second alignment electrode is directly connected to the conductive pattern.

In one or more embodiments, the pixel circuit layer may further include a second auxiliary layer. The second auxiliary layer may be directly on the second transistor electrode. The first auxiliary layer and the second auxiliary layer may be at the same layer and include a same material.

In one or more embodiments, the first auxiliary layer may not be on the conductive pattern.

In one or more embodiments, the first transistor electrode and the second transistor electrode may be in a layer different from a layer in which the gate electrode is located.

In one or more embodiments, the pixel circuit layer may further include a first insulating layer on the buffer layer. The conductive pattern may be on the first insulating layer. The gate electrode and the conductive pattern may be at the same layer.

In one or more embodiments, the gate electrode, the first transistor electrode, the second transistor electrode, and the conductive pattern may be at a same layer.

In one or more embodiments, the pixel circuit layer may include: a first bottom metal layer under the second transistor electrode; and a buffer layer covering the first bottom metal layer. The first auxiliary layer may be directly on the first bottom metal layer.

In one or more embodiments, the first transistor electrode, the second transistor electrode, and the first bottom metal layer may include titanium (Ti) and copper (Cu).

In one or more embodiments, the display element layer may include: a first alignment electrode under the first pixel electrode; and a second alignment electrode under the second pixel electrode. One alignment electrode from among the first alignment electrode and the second alignment electrode may be directly connected to the second transistor electrode.

In one or more embodiments, the pixel circuit layer may further include: a second bottom metal layer spaced from the first bottom metal layer; and a second auxiliary layer directly on the second bottom metal layer. The second transistor electrode may be directly connected to the second auxiliary layer.

In one or more embodiments, the gate electrode, the first transistor electrode, and the second transistor electrode may be at a same layer.

In one or more embodiments, the pixel circuit layer may include: a first bottom metal layer on a substrate; and a buffer layer covering the first bottom metal layer. The first transistor may be on the buffer layer. The display element layer may include: a first alignment electrode under the first pixel electrode; and a second alignment electrode under the second pixel electrode. One alignment electrode from among the first alignment electrode and the second alignment electrode may be directly connected to the first bottom metal layer through a contact hole.

One or more embodiments of the present disclosure may provide a display device including: a substrate; a first bottom metal layer on the substrate; a first auxiliary layer directly on the first bottom metal layer; a buffer layer covering the first bottom metal layer; a first transistor on the buffer layer; a light emitting element on the first transistor; a first pixel electrode electrically connected to a first end of the light emitting element; and a second pixel electrode electrically connected to a second end of the light emitting element. The first transistor may include a first transistor electrode and a second transistor electrode. The second pixel electrode may be connected to the first bottom metal layer by the first auxiliary layer.

In one or more embodiments, the first auxiliary layer may include indium tin oxide (ITO).

In one or more embodiments, the display device may further include a first alignment electrode under the first pixel electrode; and a second alignment electrode under the second pixel electrode. One alignment electrode from among the first alignment electrode and the second alignment electrode may be directly connected to one transistor electrode of the first transistor electrode and the second transistor electrode.

In one or more embodiments, the display device may further include a second bottom metal layer and a fourth bottom metal layer on the substrate. The first transistor electrode may be connected to the fourth bottom metal layer by a fourth auxiliary layer on the fourth bottom metal layer. The second transistor electrode may be electrically connected to the second bottom metal layer by a second auxiliary layer on the second bottom metal layer.

One or more embodiments of the present disclosure may provide a display device including: a substrate; a first bottom metal layer on the substrate; a first auxiliary layer directly on the first bottom metal layer; a buffer layer covering the first bottom metal layer; a first transistor on the buffer layer, and including a first transistor electrode and a second transistor electrode; a light emitting element on the first transistor; a first pixel electrode electrically connected to a first end of the light emitting element; and a second pixel electrode electrically connected to a second end of the light emitting element. The second pixel electrode may be connected to the first bottom metal layer by the first auxiliary layer. The second pixel electrode may directly contact the first auxiliary layer.

According to an aspect, there is provided a display device as set out in claim 1. Additional features are set out in claims 2 to 11. According to an aspect, there is provided a display device as set out in claim 12. Additional features are set out in claims 13 and 14. According to an aspect, there is provided a display device as set out in claim 15.

### BRIEF DESCRIPTION OF THE DRAWINGS

FIG. 1 is a plan view illustrating a display device in accordance with one or more embodiments.
FIG. 2 is a circuit diagram illustrating a sub-pixel included in the display device of FIG. 1 in accordance with one or more embodiments.
FIG. 3A is a sectional view illustrating a sub-pixel included in the display device of FIG. 1 in accordance with one or more embodiments.
FIG. 3B is a sectional view illustrating an example of a pad area of FIG. 1.
FIGS. 4A to 4D are schematic sectional views illustrating a method of fabricating a display device including the sub-pixel of FIG. 3A.
FIG. 5 is a sectional view illustrating a sub-pixel included in the display device of FIG. 1 in accordance with one or more embodiments.
FIGS. 6A to 6E are schematic sectional views illustrating a method of fabricating a display device including a sub-pixel of FIG. 5.
FIG. 7 is a sectional view illustrating a sub-pixel included in the display device of FIG. 1 in accordance with one or more embodiments.
FIGS. 8A to 8E are schematic sectional views illustrating a method of fabricating a display device including the sub-pixel of FIG. 7.
FIG. 9 is a sectional view illustrating a sub-pixel included in the display device of FIG. 1 in accordance with one or more embodiments.
FIGS. 10A and 10B are schematic sectional views illustrating a method of fabricating a display device including a sub-pixel of FIG. 9.
FIG. 11 is a sectional view illustrating a sub-pixel and a pad that are included in the display device of FIG. 1 in accordance with one or more embodiments.
FIG. 12 is a sectional view illustrating a sub-pixel and a pad that are included in the display device of FIG. 1 in accordance with one or more embodiments.
FIG. 13 is a sectional view illustrating first to third sub-pixels of FIG. 1.
FIGS. 14 and 15 are diagrams each illustrating a light emitting element in accordance with one or more embodiments.

### DETAILED DESCRIPTION

One or more embodiments of the present disclosure will hereinafter be described in detail with reference to the accompanying drawings. The same reference numerals are used throughout the different drawings to designate the same components, and repetitive description of the same components will be omitted. Further, expressions such as "at least one of A, B, and C," "at least one of A, B, or C," "A, B, and/or C," or "at least one selected from among A, B, and C" should be interpreted to mean any of "A," "B," "C," "AB," "AC," "BC," or "ABC."

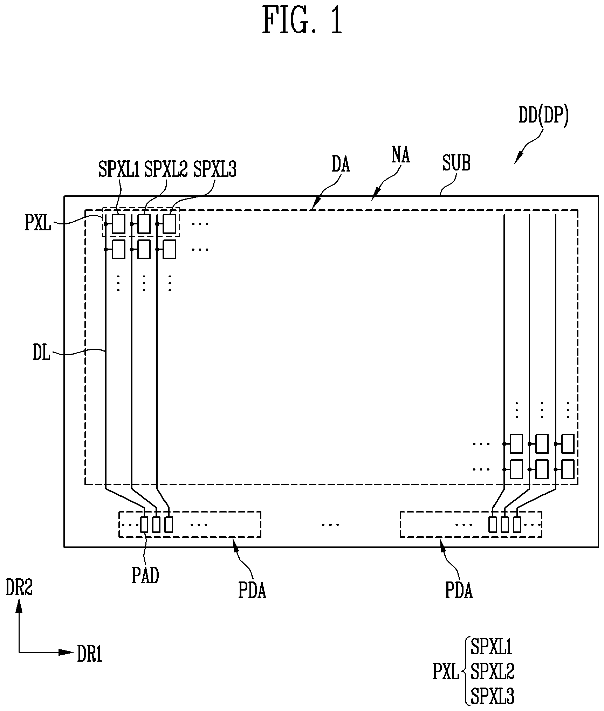

FIG. 1 is a plan view illustrating a display device in accordance with one or more embodiments.

FIG. 1 schematically illustrates the structure of the display panel DP, focused on a display area DA. In one or more embodiments, at least one driving circuit (e.g., at least one of a scan driver and a data driver), lines, and/or pads may be further provided on the display panel DP.

If the display device DD is an electronic device having a display surface on at least one surface thereof, e.g., a smartphone, a television, a tablet PC, a mobile phone, a video phone, an electronic reader, a desktop PC, a laptop PC, a netbook computer, a workstation, a server, a PDA, a portable multimedia player (PMP), an MP3 player, a medical appliance, a camera, and/or a wearable device, the present disclosure may be applied to the display device DD.

Referring to FIG. 1, the display panel DP may include a substrate SUB (or a base layer), and a pixel PXL provided on the substrate SUB.

The display panel DP may have various shapes. For example, the display panel DP may be provided in the form of a rectangular plate, but embodiments of the present disclosure are not limited thereto. For instance, the display panel DP may have a circular or elliptical shape. Furthermore, the display panel DP may have an angled corner and/or curved corner. For convenience of explanation, FIG. 1 illustrates that the display panel DP has a rectangular planar shape. In addition, in FIG. 1, an extension direction (e.g., a horizontal direction) of a long side of the display panel DP is designated as a first direction DR1, and an extension direction (e.g., a vertical direction) of a short side thereof is designated as a second direction DR2.

The substrate SUB may form a base of the display panel DP and may be a rigid or flexible substrate or film. For example, the substrate SUB may be a rigid substrate made of glass or reinforced glass, a flexible substrate (or a thin film) formed of plastic or metal, or at least one insulating layer. The material and/or properties of the substrate SUB are not particularly limited.

The substrate SUB (or the display panel DP) may include a display area DA configured to display an image, and a non-display area NA formed in an area other than the display area DA along an edge or periphery of the display area DA. The display area DA may form a screen on which an image is displayed. The non-display area NA may be located on at least one side of the display area DA. For example, the non-display area NA may enclose the display area DA, but embodiments of the present disclosure are not limited thereto.

The pixel PXL may be disposed in the display area DA on the substrate SUB. The non-display area NA may be disposed around the display area DA. Various lines, pads, and/or internal circuits that are connected to the pixels PXL of the display area DA may be disposed in the non-display area NA. The non-display area NA may include a pad area PDA, and pads PAD may be disposed in the pad area PDA. For example, the pads PAD may be connected to a driving circuit such as a source driver or a timing controller that is mounted on a flexible circuit substrate. In the case where the display panel DP is connected to a plurality of source drivers, the pad area PDA may correspond to each of the source drivers.

Each of the pixels PXL may be connected to a corresponding one of the pads PAD through a data line DL, and may receive a data signal from the source driver. In the case where an internal circuit (e.g., a gate driver) is provided in the display panel DP, the internal circuit may be connected to the pads PAD. Although FIG. 1 illustrates that the pads PAD (or the pad area PDA) are disposed on only a lower side of the display panel DP, embodiments of the present disclosure are not limited thereto. For example, the pads PAD may be disposed on each of the upper and lower sides of the display panel DP.

In the description of one or more embodiments of the present disclosure, the term "connection (or coupling)" may collectively refer to physical and/or electrical connection (or coupling). Furthermore, the term "connection (or coupling)" may collectively refer to direct or indirect connection (or coupling) and integral or non-integral connection (or coupling).

Each of the pixels PXL may include sub-pixels SPXL1 to SPXL3. For example, the pixel PXL may include a first sub-pixel SPXL1, a second sub-pixel SPXL2, and a third sub-pixel SPXL3.

Each of the sub-pixels SPXL1 to SPXL3 may emit a certain color of light. In one or more embodiments, the sub-pixels SPXL1 to SPXL3 may emit different colors of light. For example, the first sub-pixel SPXL1 may emit a first color of light. The second sub-pixel SPXL2 may emit a second color of light. The third sub-pixel SPXL3 may emit a third color of light. For example, the first sub-pixel SPXL1 may be a red pixel configured to emit red light, the second sub-pixel SPXL2 may be a green pixel configured to emit green light, and the third sub-pixel SPXL3 may be a blue pixel configured to emit blue light. However, embodiments of the present disclosure are not limited to the foregoing.

In one or more embodiments, the first sub-pixel SPXL1, the second sub-pixel SPXL2, and the third sub-pixel SPXL3 may respectively include, as light sources, a light emitting element related to the first color, a light emitting element related to the second color, and a light emitting element related to the third color, so that the first, second, and third sub-pixels SPXL1, SPXL2, and SPXL3 may respectively emit the first color of light, the second color of light, and the third color of light. In one or more embodiments, the first sub-pixel SPXL1, the second sub-pixel SPXL2, and the third sub-pixel SPXL3 may respectively include light emitting elements configured to emit the same color of light, and color conversion layers and/or color filters pertaining to different colors may be disposed on the respective light emitting elements so that the first, second, and third sub-pixels SPXL1, SPXL2, and SPXL3 may respectively emit the first color of light, the second color of light, and the third color of light. However, the colors, the types, and/or the number of sub-pixels SPXL1 to SPXL3 that form each pixel PXL are not particularly limited. In other words, the color of light to be emitted from each pixel PXL may be changed in various ways.

The sub-pixels SPXL1 to SPXL3 may be regularly arranged according to a stripe or PENTILE^{®} arrangement structure, or the like. The PENTILE^{®} arrangement structure may be referred to as an RGBG matrix structure (e.g., a PENTILE^{®} matrix structure or an RGBG structure (e.g., a PENTILE^{®} structure)). PENTILE^{®} is a registered trademark of Samsung Display Co., Ltd., Republic of Korea. For example, the first, second, and third sub-pixels SPXL1, SPXL2, and SPXL3 may be sequentially repeatedly disposed along a first direction DR1, and also may be repeatedly disposed along a second direction DR2 crossing the first direction DR1. At least one first sub-pixel SPXL1, at least one second sub-pixel SPXL2, and at least one third sub-pixel SPXL3 that are disposed adjacent to each other may form one pixel PXL that may emit various colors of light. The arrangement structure of the sub-pixels SPXL1 to SPXL3 is not limited thereto, and the sub-pixels SPXL1 to SPXL3 may be arranged in the display area DA in various structures and/or schemes.

In one or more embodiments, each of the sub-pixels SPXL1 to SPXL3 may be formed of an active pixel. For example, each of the sub-pixels SPXL1 to SPXL3 may include at least one light source (e.g., a light emitting element) that is driven by a control signal (e.g., a scan signal and a data signal) and/or a power supply (e.g., a first power supply and a second power supply). However, the types, structures, and/or driving schemes of the sub-pixels SPXL1 to SPXL3 applicable to the display device DD are not particularly limited.

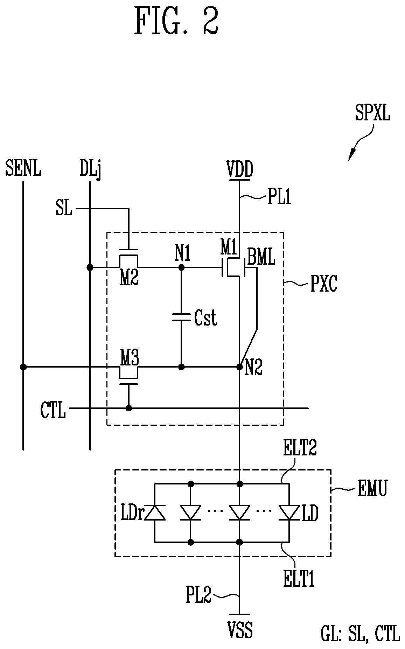

For example, FIG. 2 illustrates an electrical connection relationship of components included in each of the first, second, and third sub-pixels SPXL1, SPXL2, and SPXL3 that can be applied to an active matrix type display device in accordance with one or more embodiments. Here, the connection relationship of the components of each of the sub-pixels SPXL1, SPXL2, and SPXL3 is not limited thereto.

Hereinafter, the first sub-pixel SPXL1, the second sub-pixel SPXL2, and the third sub-pixel SPXL3 are collectively referred to as a sub-pixel SPXL.

FIG. 2 is a circuit diagram illustrating a sub-pixel SPXL included in the display device of FIG. 1 in accordance with one or more embodiments.

The sub-pixel SPXL illustrated in FIG. 2 may be any one of the sub-pixels SPXL1 to SPXL3 illustrated in FIG. 1. The sub-pixels SPXL1 to SPXL3 arranged in each display area DA may have a substantially identical or similar configuration.

Referring to FIG. 2, the sub-pixel SPXL may be connected to at least one gate line GL (e.g., a scan line SL or a control line CTL), a data line DLj, a sensing line SENL, a first power line PL1, and a second power line PL2. Furthermore, the pixel PXL may be selectively further connected to at least one other power line and/or signal line.

The sub-pixel SPXL may include an emission component EMU configured to emit light having a luminance corresponding to a data signal. Furthermore, the pixel PXL may selectively further include a pixel circuit PXC configured to drive the emission component EMU.

The pixel circuit PXC may be connected to the corresponding gate line GL (e.g., a scan line SL or a control line CTL), the corresponding a sensing line SENL, and the corresponding data line DL, and may be connected between the first power line PL1 and the emission component EMU. For example, the pixel circuit PXC may be connected to the scan line SL to which a scan signal may be supplied, a control line CTL to which a control signal or a scan signal may be supplied, a sensing line SENL which is configured to receive a sensing signal (e.g., to sense a voltage) from the pixel to measure characteristics of the pixel, the data line DL to which a data signal may be supplied, the first power line PL1 to which a voltage of a first power supply VDD may be applied, and a second pixel electrode ELT2 of the emission component EMU. The pixel circuit PXC may be selectively connected to the control line CTL to which a scan signal may be supplied, and a sensing line SENL that is connected to a reference power supply (or an initialization power supply) or a sensing circuit in response to a display period or a sensing period. In this case, the gate line GL may include the scan line SL and the control line CTL.

The pixel circuit PXC may include at least one transistor and a capacitor. For example, the pixel circuit PXC may include a first transistor M1, a second transistor M2, a third transistor M3, and a capacitor Cst.

The first transistor M1 may be connected between the first power line PL1 and a second node N2. The second node N2 may be a node to which the pixel circuit PXC and the emission component EMU are connected, and, for example, may be a node (referred to as "source node of the first transistor M1" or "anode node of the sub-pixel SPXL") to which a first electrode (e.g., a source electrode) of the first transistor M1 and a second pixel electrode ELT2 of the emission component EMU are connected. A gate electrode of the first transistor M1 may be connected to a first node N1. The first transistor M1 may control driving current to be supplied to the emission component EMU in response to a voltage of the first node N1. In other words, the first transistor M1 may be a driving transistor of the pixel PXL.

In one or more embodiments, the first transistor M1 may selectively further include a bottom metal layer BML (or a back gate electrode). The gate electrode and the bottom metal layer BML of the first transistor M1 may overlap each other with an insulating layer interposed therebetween. In one or more embodiments, the bottom metal layer BML may be connected to one electrode of the first transistor M1, e.g., the source electrode of the first transistor M1.

One or more embodiments in which the first transistor M1 includes the bottom metal layer BML may employ a back-biasing technique (or a sync technique) of shifting a threshold voltage of the first transistor M1 in a negative direction or a positive direction by applying a back-biasing voltage to the bottom metal layer BML of the first transistor M1. In the case where the bottom metal layer BML is disposed under a semiconductor pattern that forms a channel of the first transistor M1 to block light from being incident on the semiconductor pattern, operating characteristics of the first transistor M1 may be stabilized.

The second transistor M2 may be connected between the data line DL and the first node N1. A gate electrode of the second transistor M2 may be connected to the scan line SL. When a scan signal of a gate-on voltage (e.g., a high-level voltage) is supplied from the scan line SL, the second transistor M2 is turned on to connect the data line DL (e.g., a jth data line DLj) with the first node N1.

During each frame period, a data signal of a corresponding frame is supplied to the data line DL, and the data signal is transmitted to the first node N1 through the second transistor M2 during a period in which the scan signal having the gate-on voltage is supplied to the scan line SL. In other words, the second transistor M2 may be a switching transistor configured to transmit each data signal to the interior of the pixel PXL.

One electrode of the capacitor Cst may be connected to the first node N1, and a remaining electrode thereof may be connected to the second node N2. The capacitor Cst may be charged with a voltage corresponding to a data signal to be supplied to the first node N1 during each frame period.

The third transistor M3 may be connected between the second node N2 and the sensing line SENL. A gate electrode of the third transistor M3 may be connected to the control line CTL. When a control signal having a gate-on voltage (e.g., a high-level voltage) is supplied from the control line CTL, the third transistor M3 may be turned on so that a reference voltage (or an initialization voltage) supplied to the sensing line SENL may be transmitted to the second node N2, or the voltage of the second node N2 may be transmitted to the sensing line SENL. The voltage of the second node N2 that is transmitted to the sensing circuit through the sensing line SENL may be provided to an external circuit (e.g., a timing controller), and may be used to compensate for a characteristic deviation of the sub-pixel SPXL.

Although FIG. 2 illustrates that all of the transistors included in the pixel circuit PXC are N-type transistors, embodiments of the present disclosure are not limited thereto. For example, at least one of the first, second, and third transistors M1, M2, and M3 may be changed to a P-type transistor. The structure and driving method of the sub-pixel SPXL may be changed in various ways depending on embodiments.

The emission component EMU may include a first pixel electrode ELT1, a second pixel electrode ELT2, and at least one light emitting element LD, which are connected between the first power line PL1 and the second power line PL2 (and between the second pixel electrode ELT2 and the first pixel electrode ELT1). For example, the emission component EMU may include a second pixel electrode ELT2 connected to the first power line PL1 through the first transistor M1, a first pixel electrode ELT1 connected to the second power line PL2, and at least one light emitting element LD connected between the first pixel electrode ELT1 and the second pixel electrode ELT2. In one or more embodiments, the emission component EMU may include a plurality of light emitting elements LD that are connected in parallel to each other between the first pixel electrode ELT1 and the second pixel electrode ELT2.

The voltage of the first power supply VDD to be supplied to the first power line PL1 and a voltage of a second power supply VSS to be supplied to the second power line PL2 may have different potentials. For example, the first power supply VDD may be a high-potential power supply, and the second power supply VSS may be a low-potential power supply. A difference in potential between the first power supply VDD and the second power supply VSS may be set to a value equal to or greater than the threshold voltage of the light emitting elements LD. In this case, the first pixel electrode ELT1 may be an anode electrode of the emission component EMU, and the second pixel electrode ELT2 may be a cathode electrode of the emission component EMU.

Each light emitting element LD may be connected in a forward direction between the first power supply VDD and the second power supply VSS, and may form a valid light source. Such valid light sources may be grouped to form the emission component EMU of the pixel PXL.

The light emitting elements LD may emit light at a luminance corresponding to driving current supplied thereto through the pixel circuit PXC. During each frame period, the pixel circuit PXC may supply driving current corresponding to a data signal to the emission component EMU. The driving current supplied to the emission component EMU may be divided into parts that flow into the light emitting elements LD. Hence, each of the light emitting elements LD may emit light having a luminance corresponding to current applied thereto, so that the emission component EMU may emit light having a luminance corresponding to the driving current. In one or more embodiments, the light emitting element LD may have a rod-like shape, a bar-like shape, or a pillar-like shape. Alternatively, the light emitting element LD may have a rod-like shape, a bar-like shape, or a pillar-like shape that is shorter in the longitudinal direction than in the transverse direction (or has an aspect ratio less than 1).

In one or more embodiments, the emission component EMU may further include at least one invalid light source. For example, the emission component EMU may further include an invalid light emitting element LDr, which is connected in a reverse direction between the first and second pixel electrodes ELT1 and ELT2 or is incompletely connected between the first and second pixel electrodes ELT1 and ELT2.

Although FIG. 2 illustrates an embodiment in which the pixel PXL includes the emission component EMU having a parallel structure, embodiments of the present disclosure are not limited thereto. For example, in one or more embodiments, the sub-pixel SPXL may include an emission component EMU having a series structure or a series/parallel structure. In this case, the emission component EMU may include a plurality of light emitting elements LD that are connected in series or series/parallel to each other between the first pixel electrode ELT1 and the second pixel electrode ELT2. In one or more embodiments, the sub-pixel SPXL may include only a single light emitting element LD connected between the first pixel electrode ELT1 and the second pixel electrode ELT2.

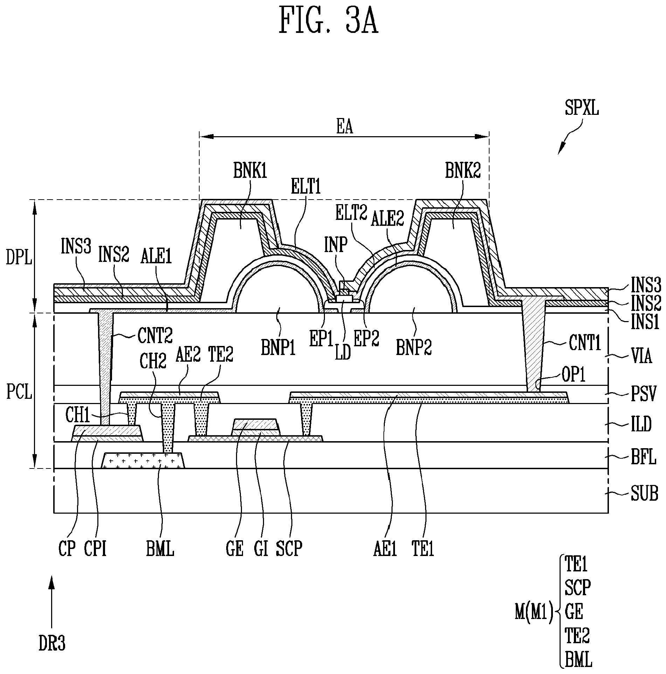

FIG. 3A is a sectional view illustrating a sub-pixel SPXL included in the display device of FIG. 1 in accordance with one or more embodiments.

FIG. 3A illustrates a first transistor M1, a first auxiliary layer AE1, and a second auxiliary layer AE2 as examples of circuit elements that may be disposed on the pixel circuit layer PCL.

Referring to FIG. 3A, the sub-pixel SPXL (or the display device) may include a pixel circuit layer PCL and a display element layer DPL that are disposed on the substrate SUB. Although FIG. 3A illustrates that the pixel circuit layer PCL is disposed on the substrate SUB, the substrate SUB may be included in the pixel circuit layer PCL.

The pixel circuit layer PCL may include at least a first transistor M1, a conductive pattern CP, and a plurality of insulating layers BFL, ILD, PSV, and VIA. The pixel circuit layer PCL may selectively further include a bottom metal layer BML.

The pixel circuit layer PCL may include at least one or more insulating layers disposed on the substrate SUB. In one or more embodiments, the pixel circuit layer PCL may include a buffer layer BFL, an interlayer insulating layer ILD, a passivation layer PSV, and a via layer VIA that are successively stacked on one surface along a third direction DR3.

A first conductive layer may be disposed between the substrate SUB and the buffer layer BFL. The first conductive layer may include a conductive material. The conductive material may include at least one of various metallic materials including silver (Ag), magnesium (Mg), aluminum (Al), platinum (Pt), palladium (Pd), gold (Au), nickel (Ni), neodymium (Nd), iridium (Ir), chrome (Cr), titanium (Ti), molybdenum (Mo), copper (Cu), etc., and/or an alloy thereof. The first conductive layer may have a single-layer structure, a double-layer structure, or a multilayer structure.

The first conductive layer may include the bottom metal layer BML. The bottom metal layer BML and the second transistor electrode TE2 of the first transistor M1 may overlap each other with the buffer layer BFL and the interlayer insulating layer ILD interposed therebetween. The bottom metal layer BML may be disposed under a second transistor electrode TE2 of the first transistor M1.

Although FIG. 3A illustrates that the bottom metal layer BML overlaps the second transistor electrode TE2, at least a portion of the bottom metal layer BML may overlap the semiconductor pattern SCP. In this case, the bottom metal layer BML may function as a light shielding pattern to stabilize operating characteristics of the first transistor M1. Furthermore, the bottom metal layer BML may be physically and/or electrically connected with the second transistor electrode TE2 of the first transistor M1, which will be described below, through a contact hole CH2 of the interlayer insulating layer ILD and the buffer layer BFL. Hence, the threshold voltage of the first transistor M1 may be shifted in a negative direction or a positive direction. Although FIG. 3A illustrates that the bottom metal layer BML is connected to the second transistor electrode TE2, embodiments of the present disclosure are not limited thereto. For example, the bottom metal layer BML may be physically and/or electrically connected to the first transistor electrode TE1.

In one or more embodiments, the first transistor M1 may not include the bottom metal layer BML. In this case, the buffer layer BFL may be directly disposed on the substrate SUB.

The buffer layer BFL may be located on the substrate SUB and cover the bottom metal layer BML.

The buffer layer BFL may prevent impurities from diffusing into the pixel circuit layer PCL. The buffer layer BFL may include inorganic insulating material. For example, the inorganic material may include at least one of silicon nitride (SiNₓ), silicon oxide (SiOₓ), silicon oxynitride (SiOₓN_{y}), and/or a metal oxide such as aluminum oxide (AlOₓ). The buffer layer BFL may be omitted depending on the material of the substrate SUB or processing conditions.

The pixel circuit layer PCL may include at least one transistor M. The transistor M may be a driving transistor configured to control driving current of the light emitting element (e.g., the light emitting element LD of FIG. 2), and have the same configuration as the first transistor M1 described with reference to FIG. 2.

The first transistor M1 may include a semiconductor pattern SCP, a gate electrode GE, a first transistor electrode TE1, and a second transistor electrode TE2.

The semiconductor pattern SCP of the first transistor M1 may be located on the buffer layer BFL. In one or more embodiments, the semiconductor pattern SCP may include a first contact area (or a first doped area) connected to the first transistor electrode TE1, a second contact area (or a second doped area) connected to the second transistor electrode TE2, and a channel area formed between the first contact area and the second contact area. For example, the first contact area and the second contact area each may be formed of a semiconductor layer that is doped with an impurity, and the channel area may be formed of an undoped semiconductor layer. For example, an n-type impurity may be used as the impurity, but embodiments of the present disclosure are not limited thereto.

The channel area of the semiconductor pattern SCP may be an area that overlaps the gate electrode GE of the first transistor M1 in a thickness direction of the substrate SUB (i.e., a third direction DR3). The first contact area of the semiconductor pattern SCP may contact one end of the channel area. Furthermore, the first contact area may be connected to the first transistor electrode TE1. The second contact area of the semiconductor pattern SCP may contact the other end of the channel area. Furthermore, the second contact area may be connected to the second transistor electrode TE2.

The semiconductor pattern SCP may be a semiconductor pattern formed of polycrystalline silicon, amorphous silicon, an oxide semiconductor, etc. In one or more embodiments, the semiconductor pattern SCP may be a semiconductor layer formed of poly silicon, amorphous silicon, an oxide semiconductor, and/or the like.

A gate insulating layer GI (or a first gate insulating layer) may be disposed on the semiconductor pattern SCP. The gate insulating layer GI may be partially disposed on the semiconductor pattern SCP. In one or more embodiments, the gate insulating layer GI may be disposed to overlap the channel area of the semiconductor pattern SCP.

The gate insulating layer GI may include inorganic material. However, embodiments of the present disclosure are not limited to the foregoing, and the gate insulating layer GI may include organic material. For example, the organic layer may include, for example, at least one selected from among polyacrylate resin, epoxy resin, phenolic resin, polyamide resin, polyimide rein, unsaturated polyester resin, polyphenylen ether resin, poly-phenylene sulfide resin, and/or benzocyclobutene resin.

The gate electrode GE may be disposed on the gate insulating layer GI. The gate electrode GE may be disposed on the gate insulating layer GI to overlap the channel area of the semiconductor pattern SCP in the third direction DR3.

The gate electrode GE may have a single-layer structure including copper (Cu), silver (Ag), chrome (Cr), molybdenum (Mo), aluminum (Al), titanium (Ti), manganese (Mn), and/or an alloy thereof, or may have a multilayer structure including a plurality metal layers having different materials.

An interlayer insulating layer ILD may be disposed on the gate electrode GE. For example, the interlayer insulating layer ILD may be disposed between the gate electrode GE and the first and second transistor electrodes TE1 and TE2. The interlayer insulating layer ILD may be formed of a single layer or multiple layers, and may include various inorganic materials including silicon oxide (SiOₓ), silicon nitride (SiNₓ), silicon oxynitride (SiOₓN_{y}), aluminum nitride (AlNₓ), aluminum oxide (AlOₓ), zirconium oxide (ZrOₓ), hafnium oxide (HfOₓ), and/or titanium oxide (TiOₓ).

The first transistor electrode TE1 and the second transistor electrode TE2 may be provided and/or disposed on the interlayer insulating layer ILD. The first transistor electrode TE1 and the second transistor electrode TE2 may be disposed at positions spaced from each other. The first and second transistor electrodes TE1 and TE2 may be disposed to overlap with the semiconductor pattern SCP in the third direction DR3. The first and second transistor electrodes TE1 and TE2 may be electrically connected to the semiconductor pattern SCP. For example, the first transistor electrode TE1 may contact the first contact area of the semiconductor pattern SCP through a contact hole passing through the interlayer insulating layer ILD. The second transistor electrode TE2 may contact the second contact area of the semiconductor pattern SCP through a contact hole passing through the interlayer insulating layer ILD.

In one or more embodiments, one of the first and second transistor electrodes TE1 and TE2 may be a source electrode, and the other one may be a drain electrode.

The second transistor electrode TE2 may be physically and/or electrically connected with the conductive pattern CP through a contact hole CH1 passing through the interlayer insulating layer ILD. The second transistor electrode TE2 may be physically and/or electrically connected with the bottom metal layer BML through the contact hole CH2 passing through the interlayer insulating layer ILD and the buffer layer BFL.

The first and second transistor electrodes TE1 and TE2 may include titanium (Ti) and copper (Cu).

The first auxiliary layer AE1 and a second auxiliary layer AE2 may be disposed on the first and second transistor electrodes TE1 and TE2. The first auxiliary layer AE1 may be directly disposed on the first transistor electrode TE1. The second auxiliary layer AE2 may be directly disposed on the second transistor electrode TE2.

The first and second auxiliary layers AE1 and AE2 may include indium tin oxide (ITO).

The first transistor electrode TE1 may be electrically connected with a second pixel electrode ELT2, which will be described below, through the first auxiliary layer AE1. The first auxiliary layer AE1 may be physically and/or electrically connected with the second pixel electrode ELT2 through a first contact hole CNT1.

A first lower insulating layer CPI may be disposed on the buffer layer BFL. The conductive pattern CP may be disposed on the first lower insulating layer CPI. At least a portion of the conductive pattern CP may be disposed to overlap the second transistor electrode TE2 in the third direction DR3. The conductive pattern CP may be connected and/or brought into contact with a first alignment electrode ALE1, which will be described below, through a second contact hole CNT2.

The first lower insulating layer CPI may be formed of a single layer or multiple layers, and include an inorganic insulating layer including at least one inorganic material or an organic insulating layer including at least one organic material.

The passivation layer PSV may be disposed over the circuit elements including the first transistor M1. The passivation layer PSV may be formed of organic material for planarizing a stepped structure provided therebelow. For example, the passivation layer PSV may include organic material such as acrylic resin, epoxy resin, phenolic resin, polyamide resin, polyimide resin, polyester resin, polyphenylene sulfide resin, and/or benzocyclobutene (BCB). However, embodiments of the present disclosure are not limited to the foregoing, and the passivation layer PSV may include various types of inorganic materials.

The passivation layer PSV may include a first opening OP1 through which the first auxiliary layer AE1 is exposed. In other words, the passivation layer PSV may be partially removed in the first opening OP1, thus allowing circuit elements disposed under the passivation layer PSV to be exposed.

A via layer VIA may be disposed on the passivation layer PSV.

The display element layer DPL may be located on the via layer VIA.

The display element layer DPL may include first and second bank patterns BNP1 and BNP2, first and second alignment electrodes ALE1 and ALE2, first and second pixel electrodes ELT1 and ELT2, and a plurality of insulating layers INS1, INS2, and INS3.

The first and second bank patterns BNP1 and BNP2 may be disposed on the via layer VIA. Each of the first and second bank patterns BNP1 and BNP2 may have a semicircular cross-sectional shape that is reduced in width from one surface (e.g., an upper surface) of the via layer VIA upward in the third direction DR3. In one or more embodiments, each of the first and second bank patterns BNP1 and BNP2 may have a cross-sectional shape such as a trapezoidal shape, a semi-elliptical shape, and/or a hemispherical shape that is reduced in width from one surface of the via layer VIA upward in the third direction DR3. In a cross-sectional view, the shape of each of the first and second bank patterns BNP1 and BNP2 is not limited to the foregoing examples, and may be changed in various ways within a range in which the efficiency of light emitted from each of the light emitting elements LD can be enhanced.

Each of the first and second bank patterns BNP1 and BNP2 may include inorganic material or organic material, and may be formed of a single layer or multiple layers. In one or more embodiments, the first and second bank patterns BNP1 and BNP2 may be omitted. For example, a structure corresponding to the first and second bank patterns BNP1 and BNP2 may be formed in the via layer VIA.

The first and second alignment electrodes ALE1 and ALE2 may be disposed on the via layer VIA and the first and second bank patterns BNP1 and BNP2.

The first alignment electrode ALE1 may be disposed on the first bank pattern BNP1. The second alignment electrode ALE2 may be disposed on the second bank pattern BNP2. In a cross-sectional view, the first and second alignment electrodes ALE1 and ALE2 may respectively have surface profiles corresponding to the shapes of the first and second bank patterns BNP1 and BNP2.

The first and second alignment electrodes ALE1 and ALE2 each may include conductive material having a reflectivity to enable light emitted from the light emitting element LD to travel in an image display direction (e.g., in the third direction DR3) of the display device. Each of the first and second alignment electrodes ALE1 and ALE2 may be formed of a single layer or multiple layers. In one or more embodiments, the first and second alignment electrodes ALE1 and ALE2 each may have a double-layer structure or a multilayer structure to reduce line resistance (or contact resistance), and may include one or more materials selected from among copper (Cu), molybdenum (Mo), tungsten (W), aluminum neodymium (AlNd), titanium (Ti), aluminum (Al), silver (Ag), and/or an alloy thereof.

The first alignment electrode ALE1 may be brought into contact with and/or connected with the conductive pattern CP through the second contact hole CNT2 that passes through the via layer VIA, the passivation layer PSV, and the interlayer insulating layer ILD. Although FIG. 3A illustrates that the first alignment electrode ALE1 is connected to the conductive pattern CP through the second contact hole CNT2, embodiments of the present disclosure are not limited thereto. The second alignment electrode ALE2 may be connected to the conductive pattern CP through the second contact hole CNT2.

The first and second alignment electrodes ALE1 and ALE2 may be used as alignment electrodes for aligning the light emitting elements LD during a process of fabricating the display device. After the first and second alignment electrodes ALE1 and ALE2 are used as electrodes for aligning the light emitting elements LD, the voltage of the first power supply VDD (or the voltage of the second power supply VSS) may be applied to the first alignment electrode ALE1. The voltage of the second power supply VSS (or the voltage of the first power supply VDD) may be applied to the second alignment electrode ALE2. In one or more embodiments, after the first and second alignment electrodes ALE1 and ALE2 are used as electrodes for aligning the light emitting elements LD, the first and second alignment electrodes ALE1 and ALE2 may float.

The first and second alignment electrodes ALE1 and ALE2 may include one or more selected from among silver (Ag), magnesium (Mg), aluminum (Al), platinum (Pt), palladium (Pd), gold (Au), nickel (Ni), neodymium (Nd), iridium (Ir), chrome (Cr), titanium (Ti), and/or an alloy thereof. Embodiments of the present disclosure are not limited to the foregoing example.

The first insulating layer INS1 may be disposed and/or formed on the first and second alignment electrodes ALE1 and ALE2. The first insulating layer INS1 may be disposed between the first alignment electrode ALE1 and the second alignment electrode ALE2, thus preventing a short circuit from occurring between the first alignment electrode ALE1 and the second alignment electrode ALE2. The first insulating layer INS1 may include inorganic material or organic material.

The light emitting element LD may be disposed on the first insulating layer INS1. The light emitting element LD may be an inorganic light emitting diode. The light emitting element LD may be aligned between the first alignment electrode ALE1 and the second alignment electrode ALE2 such that a first end EP1 of the light emitting element LD faces the first alignment electrode ALE1, and a second end EP2 thereof faces the second alignment electrode ALE2.

The first end EP1 of the light emitting element LD may partially overlap the first alignment electrode ALE1 in the third direction DR3. The second end EP2 of the light emitting element LD may partially overlap the second alignment electrode ALE2 in the third direction DR3. However, embodiments of the present disclosure are not limited to the foregoing.

The first bank BNK1 and the second bank BNK2 may be disposed on the first insulating layer INS1. The first bank BNK1 and the second bank BNK2 each may form a dam structure configured to prevent a solution including the light emitting element LD from being drawn into the adjacent sub-pixels SPXL at the step of supplying the light emitting element LD onto the first insulating layer INS1, or to control the amount of solution such that a constant amount of solution is supplied to each sub-pixel SPXL. Furthermore, the first bank BNK1 and the second bank BNK2 may define an emission area EA. The first bank BNK1 and the second bank BNK2 may correspond to a single dam structure. The emission area EA may correspond to an opening area of the dam structure.

The first bank BNK1 and the second bank BNK2 may include organic material. In one or more embodiments, the first bank BNK1 and the second bank BNK2 may include light shielding material and/or reflective material. In this case, the first bank BNK1 and the second bank BNK2 may prevent light from leaking between the sub-pixel SPXL and sub-pixels adjacent thereto. For example, the first bank BNK1 and the second bank BNK2 may include color filter material or black matrix material. In one or more embodiments, in order to further enhance the efficiency of light emitted out of the sub-pixel SPXL, a separate reflective material layer may be provided and/or formed on the first bank BNK1 and the second bank BNK2.

An insulating pattern INP may be disposed on the light emitting element LD. The insulating pattern INP may be located on a portion of the upper surface of the light emitting element LD such that the first end EP1 and the second end EP2 of the light emitting element LD are exposed to the outside.

The insulating pattern INP may include inorganic material or organic material, depending on design conditions of the display device including the light emitting element LD. After the alignment of the light emitting element LD on the first insulating layer INS1 has been completed, the insulating pattern INP is located on the light emitting element LD so that the light emitting element LD may be prevented from being removed from the aligned position. In the case where a gap (or space) is present between the first insulating layer INS1 and the light emitting element LD before the formation of the insulating pattern INP, the gap may be filled with the insulating pattern INP during a process of forming the insulating pattern INP.

The second insulating layer INS2 may be disposed on the first bank BNK1 and the second bank BNK2. The second insulating layer INS2 may be formed of a single layer or multiple layers, and may include one or more selected from among various inorganic materials such as, for example, silicon oxide (SiOₓ), silicon nitride (SiNₓ), silicon oxynitride (SiOₓN_{y}), aluminum nitride (AlNₓ), aluminum oxide (AlOₓ), zirconium oxide (ZrOₓ), hafnium oxide (HfOₓ), and/or titanium oxide (TiOₓ).

The third insulating layer INS3 may be disposed on the second insulating layer INS2 and the second pixel electrode ELT2 and overlap the first bank BNK1.

The second pixel electrode ELT2 may be disposed on the second insulating layer INS2 and overlap the second alignment electrode ALE2 and the second bank BNK2.

The first pixel electrode ELT1 may be disposed on the third insulating layer INS3 and overlap the first alignment electrode ALE1 and the first bank BNK1.

The first pixel electrode ELT1 may be disposed on the first alignment electrode ALE1. The first pixel electrode ELT1 may directly contact the first end EP1 of the light emitting element LD. The second pixel electrode ELT2 may be disposed on the second alignment electrode ALE2. The second pixel electrode ELT2 may directly contact the second end EP2 of the light emitting element LD.

The first pixel electrode ELT1 and the second pixel electrode ELT2 may include at least one selected from among various transparent conductive materials (or substances) such as, for example, indium tin oxide (ITO), indium zinc oxide (IZO), zinc oxide (ZnOₓ), indium gallium zinc oxide (IGZO), and/or indium tin zinc oxide (ITZO), and may be substantially transparent or translucent to satisfy a certain transmittancy (or transmittance).

The second pixel electrode ELT2 may be brought into contact with or connected with the first auxiliary layer AE1 through the first contact hole CNT1 that passes through the first and second insulating layers INS1 and INS2, the via layer VIA, and the passivation layer PSV. The second pixel electrode ELT2 may electrically connect the second end EP2 of the light emitting element LD with the first transistor electrode TE1. Although FIG. 3A illustrates that the second pixel electrode ELT2 is connected to the first transistor electrode TE1 through the first contact hole CNT1, embodiments of the present disclosure are not limited thereto. The first pixel electrode ELT1 may be connected to the first transistor electrode TE1 through the first contact hole CNT1.

In one or more embodiments, the first and second pixel electrodes ELT1 and ELT2 may be physically separated from the first and second alignment electrodes ALE1 and ALE2.

In the case where the second pixel electrode ELT2 (or the first pixel electrode ELT1) is directly connected to the first transistor electrode TE1 (or the second transistor electrode TE2), contact resistance between the second pixel electrode ELT2 and the first transistor electrode TE1 is relatively large. Thus, a defect resulting from the contact resistance may be caused. Given this, in one or more embodiments, the second pixel electrode ELT2 (or the first pixel electrode ELT1) may be connected to the electrodes of the first transistor M1 (or an element including material similar to that of the electrodes of the first transistor M1) through the first auxiliary layer AE1, so that the contact resistance can be reduced.

In other words, defects resulting from reactivity between the first pixel electrode ELT1 (and/or the second pixel electrode ELT2) and electrodes that form a circuit element of the pixel circuit layer PCL may be reduced or minimized.

The third insulating layer INS3 may be disposed on the second pixel electrode ELT2. The third insulating layer INS3 may be formed of a single layer or multiple layers, and may include various types of inorganic materials.

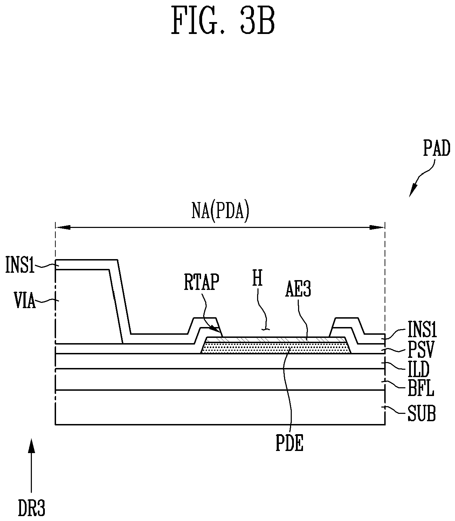

FIG. 3B is a sectional view illustrating an example of the pad area PDA of FIG. 1.

Referring to FIGS. 1 and 3B, a pad PAD may be disposed in the pad area PDA.

The substrate SUB, the buffer layer BFL, the interlayer insulating layer ILD, and the passivation layer PSV have been described with reference to FIG. 3A; therefore, repetitive explanation thereof will be omitted. Furthermore, because the first insulating layer INS1 corresponds to the first insulating layer INS1 described with reference to FIG. 3A, redundant explanation thereof will be omitted.

A pad electrode PDE may be disposed on the interlayer insulating layer ILD. The pad electrode PDE may be formed of the same conductive layer as the first and second transistor electrodes TE1 and TE2 of FIG. 3A. The pad electrode PDE may be formed through the same process as the first and second transistor electrodes TE1 and TE2, but embodiments of the present disclosure are not limited thereto.

A third auxiliary layer AE3 may be disposed on the pad electrode PDE. The third auxiliary layer AE3 may be formed through the same process as the first and second auxiliary layers AE1 and AE2 of FIG. 3A, and may have the same material as at least one of the first and second auxiliary layers AE1 and AE2 of FIG. 3A. For example, the third auxiliary layer AE3 may include transparent conductive material such as ITO.

The passivation layer PSV may be disposed on the third auxiliary layer AE3.

In one area of the pad area PDA, the via layer VIA may be formed on the passivation layer PSV. In one or more embodiments, the first insulating layer INS1 may be disposed on the via layer VIA.

The passivation layer PSV may include a hole H located in the pad area PDA. The hole H may be formed through the passivation layer PSV.

The passivation layer PSV and the first insulating layer INS1 may be partially removed from the pad area PDA. In one or more embodiments, after the passivation layer PSV and the first insulating layer INS1 are successively disposed to overlap the third auxiliary layer AE3, areas of the passivation layer PSV and the first insulating layer INS1 may be removed through a photolithography process so that one area of the third auxiliary area AE3 can be exposed to the outside.

In the process of etching the passivation layer PSV and the first insulating layer INS1, a reverse tapered surface RTAP may be formed inside the hole H of the passivation layer PSV by a difference in etching rate between the passivation layer PSV and the first insulating layer INS1. For example, the first insulating layer INS1 may be formed of silicon oxide (SiOₓ), and the passivation layer PSV may be formed of silicon nitride (SiNₓ). In this case, the hole H may be formed to have a reverse tapered surface RTAP through the photolithography process.

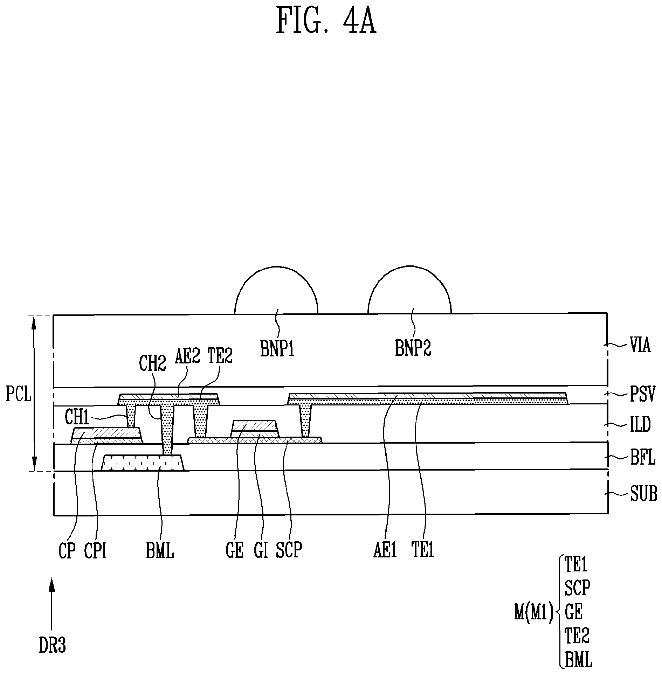

FIGS. 4A to 4D are schematic sectional views illustrating a method of fabricating a display device including the sub-pixel SPXL of FIG. 3A.

Referring to FIG. 4A, the bottom metal layer BML, the buffer layer BFL, the first lower insulating layer CPI, the conductive pattern CP, the first transistor M1, the interlayer insulating layer ILD, the passivation layer PSV, and the via layer VIA of the pixel circuit layer PCL may be formed on the substrate SUB.

Referring to FIG. 4A, the bottom metal layer BML is formed on the substrate SUB. The bottom metal layer BML may include transparent conductive material (or substance).

The buffer layer BFL may be formed on the overall surface of the substrate SUB on which the bottom metal layer BML is disposed.

Circuit elements including the first transistor M1 may be formed on the buffer layer BFL and, thereafter, the passivation layer PSV may be formed on the first transistor M1.

The semiconductor pattern SCP may be formed on the buffer layer BFL. The gate insulating layer GI may be formed in an area that overlaps the channel area of the semiconductor pattern SCP.

The gate electrode GE may be disposed on the gate insulating layer GI and overlap the channel area of the semiconductor pattern SCP.

A first lower insulating layer CPI may be formed on the buffer layer BFL. The first lower insulating layer CPI may be formed through the same process as the gate insulating layer GI, and may include the same material as the gate insulating layer GI. However, embodiments of the present disclosure are not limited to the foregoing. The first lower insulating layer CPI may be formed through a process separate from that of the gate insulating layer GI, and may include material different from that of the gate insulating layer GI.

The conductive pattern CP may be formed on the first lower insulating layer CPI. The conductive pattern CP may be formed through the same process as the gate electrode GE, and may include the same material as the gate electrode GE. However, embodiments of the present disclosure are not limited to the foregoing. The conductive pattern CP may be formed through a process separate from that of the gate electrode GE, and may include material different from that of the gate electrode GE.

The conductive pattern CP may have a single-layer structure including one or more selected from among copper (Cu), silver (Ag), chrome (Cr), molybdenum (Mo), aluminum (Al), titanium (Ti), manganese (Mn), and/or an alloy thereof, or may have a multilayer structure including a plurality metal layers having different materials.

The interlayer insulating layer ILD may be formed on the buffer layer BFL. The interlayer insulating layer ILD may include the conductive pattern CP, the semiconductor pattern SCP of the first transistor M1, and the gate electrode GE.

The first and second transistor electrodes TE1 and TE2 may be disposed on the interlayer insulating layer ILD.

The first and second transistor electrodes TE1 and TE2 may include titanium (Ti) and/or copper (Cu). The first and second auxiliary layer AE1 and AE2 may be disposed on the first and second transistor electrodes TE1 and TE2.

The first auxiliary layer AE1 may be formed through the same process as the second auxiliary layer AE2. The first auxiliary layer AE1 may have the same material as the second auxiliary layer AE2.

The passivation layer PSV may be formed on the interlayer insulating layer ILD on which the first and second transistor electrodes TE1 and TE2 are disposed. The via layer VIA may be formed on the passivation layer PSV.

The first and second bank patterns BNP1 and BNP2 may be formed on the via layer VIA. The first and second bank patterns BNP1 and BNP2 may be disposed at positions spaced from each other.

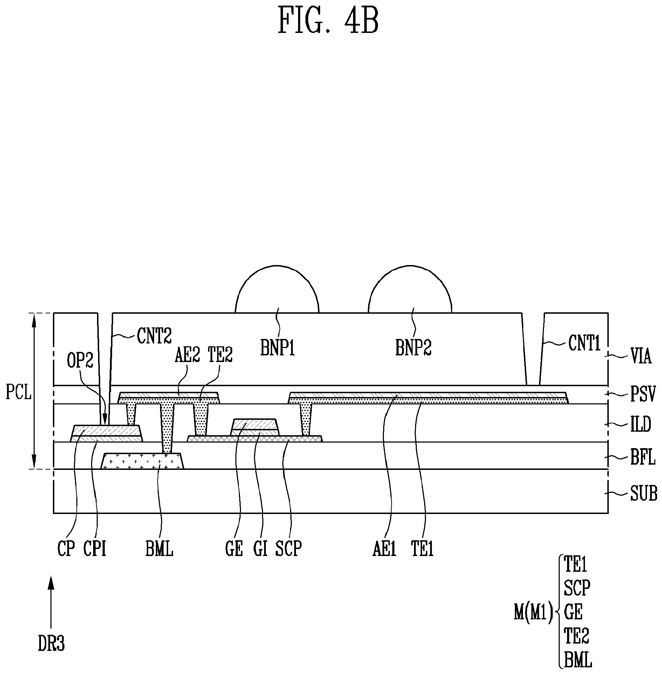

Referring to FIG. 4B, the first contact hole CNT1 and the second contact hole CNT2 may be formed in the via layer VIA.

The second contact hole CNT2 may pass through the via layer VIA, the passivation layer PSV, and the interlayer insulating layer ILD. The second contact hole CNT2 may be connected to a second opening OP2 formed in the interlayer insulating layer ILD. The conductive pattern CP may be exposed to the outside through the second contact hole CNT2 and the second opening OP2.

During a process of forming the first contact hole CNT1, because the passivation layer PSV connected to the first contact hole CNT1 is not removed, the first auxiliary layer AE1 disposed under the passivation layer PSV may not be exposed to the outside.

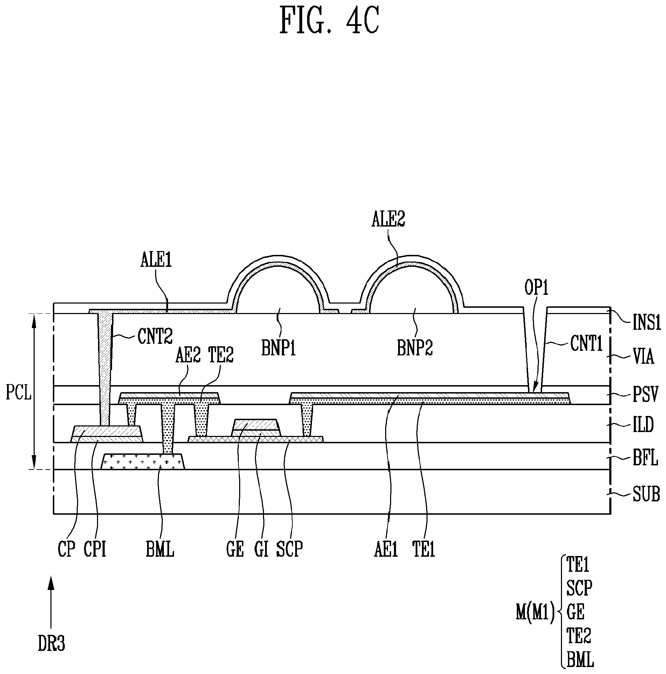

Referring to FIG. 4C, the first and second alignment electrodes ALE1 and ALE2 may be formed on the via layer VIA on which the first and second bank patterns BNP1 and BNP2 are disposed.

The first alignment electrode ALE1 may be formed to overlap the second contact hole CNT2 and the first bank pattern BNP1.

The second alignment electrode ALE2 may be formed to overlap the second bank pattern BNP2. In one or more embodiments, the second alignment electrode ALE2 may be formed not to overlap the first contact hole CNT1.

The first alignment electrode ALE1 (or the second alignment electrode ALE2) may be physically and/or electrically connected to the conductive pattern CP through the second contact hole CNT2. In one or more embodiments, the first and second alignment electrodes ALE1 and ALE2 and the conductive pattern CP may be formed of metallic material. For example, the first and second alignment electrodes ALE1 and ALE2 and the conductive pattern CP may be formed of the same material.

The first insulating layer INS1 may be formed on the first and second alignment electrodes ALE1 and ALE2.

Respective areas of the first insulating layer INS1 and the passivation layer PSV that correspond to the first contact hole CNT1 of the via layer VIA may be removed. In one or more embodiments, the first opening OP1 can be formed in the passivation layer PSV by removing the area of the passivation layer PSV that corresponds to the first contact hole CNT1.

One area of the first auxiliary area AE1 disposed on the first transistor electrode TE1 may be exposed through the first contact hole CNT1 and the first opening OP1.

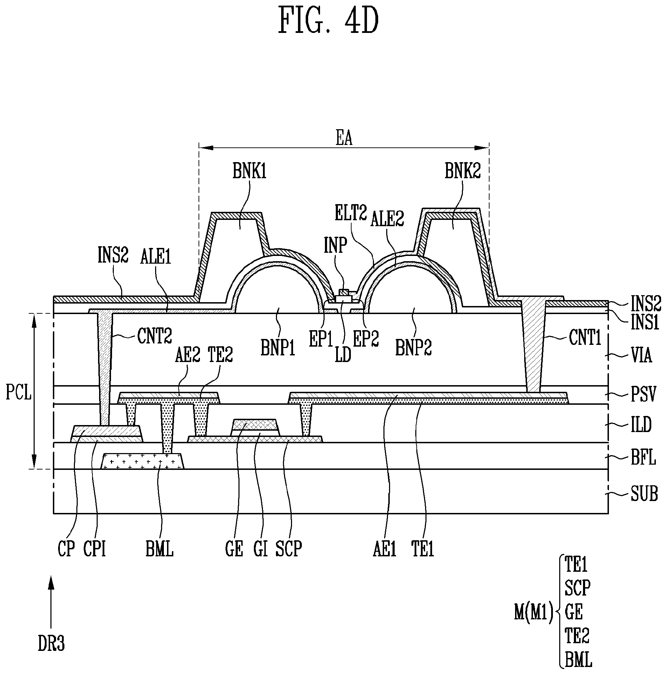

Referring to FIG. 4D, the first and second banks BNK1 and BNK2 may be formed on the first insulating layer INS1.

The light emitting element LD may be disposed in the emission area EA defined by the first and second banks BNK1 and BNK2. The light emitting element LD may be disposed between the first and second alignment electrodes ALE1 and ALE2 on the first insulating layer INS1.

The insulating pattern INP may be formed on the light emitting element LD after the light emitting element LD is aligned. The insulating pattern INP may be formed on an upper surface of the light emitting element LD such that the first end EP1 and the second end EP2 of the light emitting element LD are exposed to the outside.

The second insulating layer INS2 may be formed on the first and second banks BNK1 and BNK2.

The second pixel electrode ELT2 may be formed on the second bank BNK2 and overlap the second alignment electrode ALE2. The second pixel electrode ELT2 may be formed to overlap the first contact hole CNT1.

The second pixel electrode ELT2 may contact the first auxiliary layer AE1 through the first contact hole CNT1 and the first opening OP1. The second pixel electrode ELT2 may be electrically connected with the first transistor electrode TE1 through the first auxiliary layer AE1.

The second pixel electrode ELT2 (or the first pixel electrode ELT1) may include the same material as the first auxiliary layer AE1, or may include transparent conductive material. The second pixel electrode ELT2 (or the first pixel electrode ELT1) may be connected to the first transistor electrode TE1 through the first auxiliary layer AE1, so that defects resulting from contact resistance can be reduced or minimized.

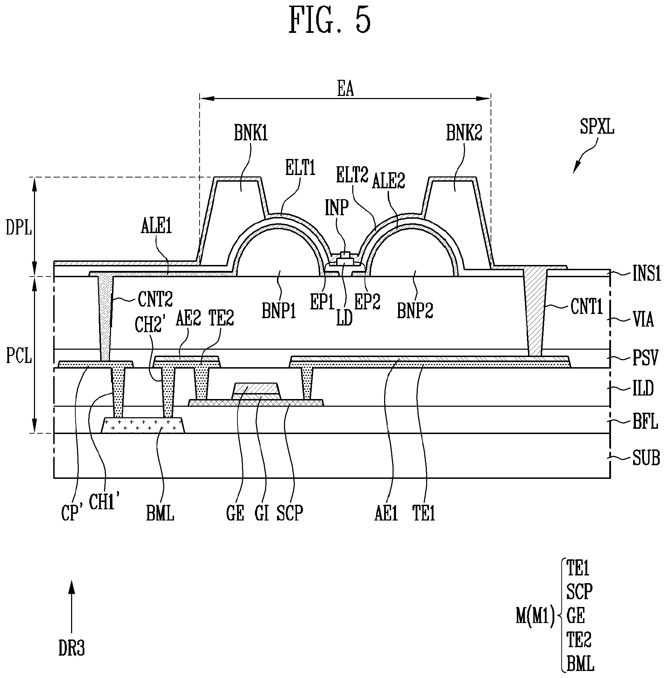

FIG. 5 is a sectional view illustrating a sub-pixel SPXL included in the display device of FIG. 1 in accordance with one or more embodiments.

Referring to FIG. 5, except a conductive pattern CP' of the pixel circuit layer PCL and a display element layer DPL, the other components are the same as the components illustrated in FIG. 3A; therefore, the same reference numerals will be used to designate identical or corresponding components, and redundant explanation thereof will be omitted.

The pixel circuit layer PCL may include a first transistor M1, a conductive pattern CP', and a plurality of insulating layers BFL, ILD, PSV, and VIA. The pixel circuit layer PCL may selectively further include a bottom metal layer BML.

The conductive pattern CP' may be disposed on the interlayer insulating layer ILD. In one or more embodiments, the conductive pattern CP' may be disposed at the same layer as the first and second transistor electrodes TE1 and TE2.

The conductive pattern CP' may be formed through the same process as the first and second transistor electrodes TE1 and TE2, and may have the same material as the first and second transistor electrodes TE1 and TE2, but is not limited thereto. The conductive pattern CP' may be formed through a process separate from the process of forming the first and second transistor electrodes TE1 and TE2, and may include material different from that of the first and second transistor electrodes TE1 and TE2.

The first alignment electrode ALE1 may contact the conductive pattern CP' through the second contact hole CNT2. The conductive pattern CP' may physically and/or electrically contact the bottom metal layer BML through a contact hole CH1' passing through the interlayer insulating layer ILD and the buffer layer BFL.

The first alignment electrode ALE1 may be electrically connected to the second transistor electrode TE2 through the conductive pattern CP' and the bottom metal layer BML.

The second transistor electrode TE2 may be physically and/or electrically connected to the bottom metal layer BML through a contact hole CH2' passing through the interlayer insulating layer ILD and the buffer layer BFL.

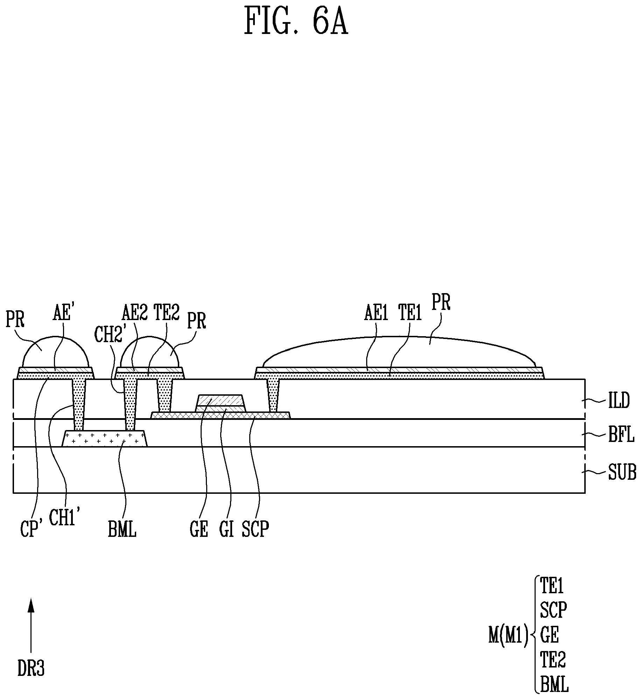

FIGS. 6A to 6E are schematic sectional views illustrating a method of fabricating a display device including the sub-pixel SPXL of FIG. 5.

Referring to FIG. 6A, the bottom metal layer BML, the buffer layer BFL, the conductive pattern CP', the first transistor M1, and the interlayer insulating layer ILD of the pixel circuit layer PCL may be formed on the substrate SUB.

The first and second transistor electrodes TE1 and TE2 and the conductive pattern CP' may be formed on the interlayer insulating layer ILD.

The conductive pattern CP' may be formed concurrently (e.g., simultaneously) with the first and second transistor electrodes TE1 and TE2, but embodiments of the present disclosure are not limited thereto. The conductive pattern CP', the first transistor electrode TE1, and the second transistor electrode TE2 may be successively formed.

An auxiliary layer AE' may be formed on the conductive pattern CP'. The auxiliary layer AE' may be formed concurrently (e.g., simultaneously) with the first and second auxiliary layers AE1 and AE2.

Referring to FIG. 6A, a photoresist pattern PR may be formed on the auxiliary layer AE', the first auxiliary layer AE1, and the second auxiliary layer AE2.

The photoresist pattern PR may be formed by developing a photoresist layer exposed to extreme ultraviolet rays. The photoresist pattern PR may have an island shape extending in one direction, or a circular shape, but is not limited thereto. For example, the photoresist pattern PR may have various shapes such as a line shape, and a honeycomb shape.

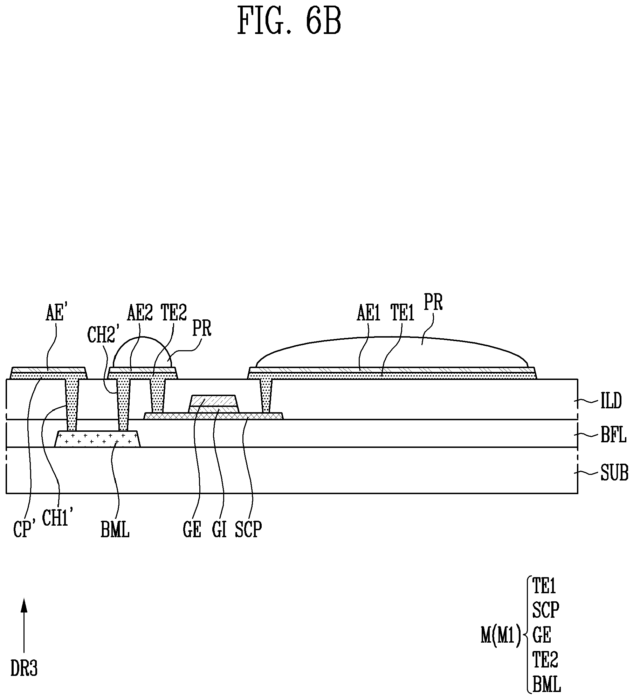

Referring to FIG. 6B, the photoresist pattern PR that is disposed on the auxiliary layer AE' may be removed. In one or more embodiments, the photoresist pattern PR that is disposed on the auxiliary layer AE' may be removed by using a halftone mask including a mask area having different transmissivity.

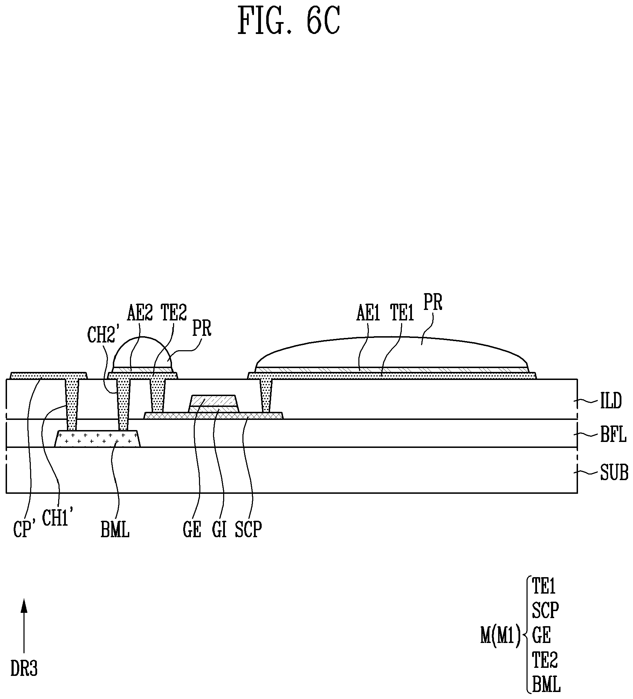

Referring to FIG. 6C, the auxiliary layer AE' that is disposed on the conductive pattern CP' may be removed. In one or more embodiments, the first auxiliary layer AE1 and the second auxiliary layer AE2 may be maintained in shape on the first transistor electrode TE1 and the second transistor electrode TE2 by the photoresist pattern, but the auxiliary layer AE' that is disposed on the conductive pattern CP' may be removed through a photolithography process.

Because the first alignment electrode ALE1 and the conductive pattern CP' are formed of metallic material, contact resistance between the first alignment electrode ALE1 and the conductive pattern CP' may be relatively low. Therefore, the first alignment electrode ALE1 may be connected to the conductive pattern CP' without a separate auxiliary layer.

Because the auxiliary layer AE' that is disposed on the conductive pattern CP' is removed, the conductive pattern CP' may be physically connected to the first alignment electrode ALE1, which will be described below.

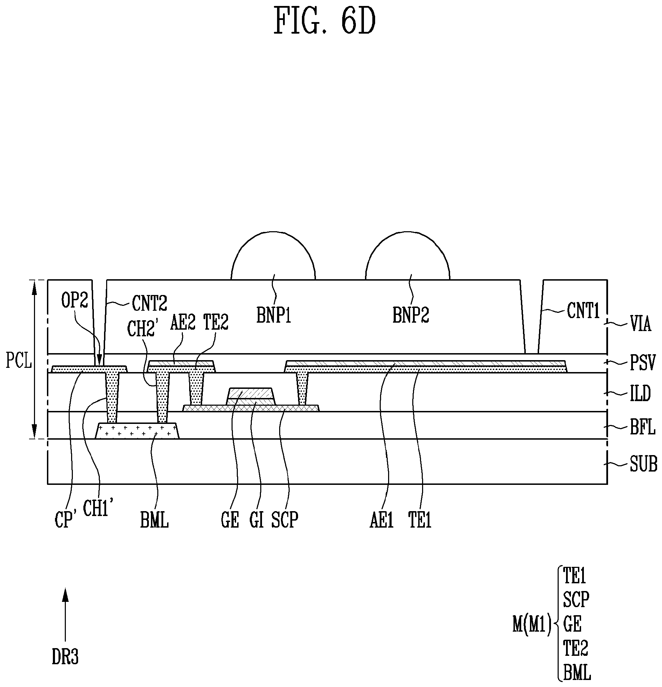

Referring to FIG. 6D, the passivation layer PSV may be formed on the interlayer insulating layer ILD. The via layer VIA may be formed on the passivation layer PSV.

Furthermore, the first contact hole CNT1 and the second contact hole CNT2 may be formed in the via layer VIA. After the via layer VIA is formed, the conductive pattern CP' may be exposed through the second opening OP2 and the second contact hole CNT2 passing through the via layer VIA and the passivation layer PSV. One area of the passivation layer PSV that overlaps the conductive pattern CP' may be removed to form the second opening OP2. One area of the passivation layer PSV may be exposed through the first contact hole CNT1 passing through the via layer VIA.

During a process of forming the first contact hole CNT1, because the passivation layer PSV connected to the first contact hole CNT1 is not removed, the first auxiliary layer AE1 disposed under the passivation layer PSV may not be exposed to the outside.

The first and second bank patterns BNP1 and BNP2 may be formed on the via layer VIA. The first and second bank patterns BNP1 and BNP2 may be disposed at positions spaced from each other.

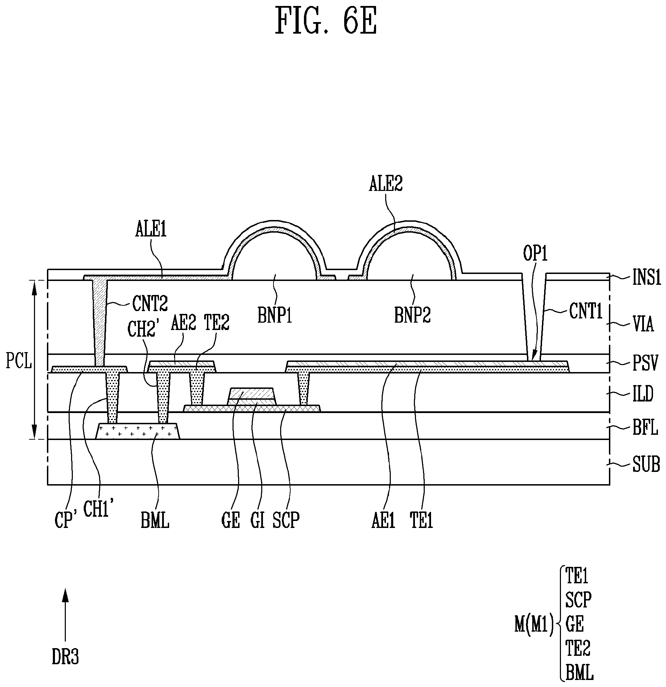

Referring to FIG. 6E, the first and second alignment electrodes ALE1 and ALE2 may be formed on the via layer VIA on which the first and second bank patterns BNP1 and BNP2 are disposed.

The first alignment electrode ALE1 may be formed to overlap the second contact hole CNT2 and the first bank pattern BNP1.

The second alignment electrode ALE2 may be formed to overlap the second bank pattern BNP2. In one or more embodiments, the second alignment electrode ALE2 may be formed not to overlap the first contact hole CNT1.

The first alignment electrode ALE1 (or the second alignment electrode ALE2) may be physically and/or electrically connected to the conductive pattern CP' through the second contact hole CNT2.

The first insulating layer INS1 may be formed on the first and second alignment electrodes ALE1 and ALE2.

Respective areas of the first insulating layer INS1 and the passivation layer PSV that correspond to the first contact hole CNT1 of the via layer VIA may be removed. In one or more embodiments, the first opening OP1 can be formed in the passivation layer PSV by removing the area of the passivation layer PSV that corresponds to the first contact hole CNT1.

A sectional view illustrating a processing step to be performed after the first opening OP1 is formed may correspond to FIG. 5.

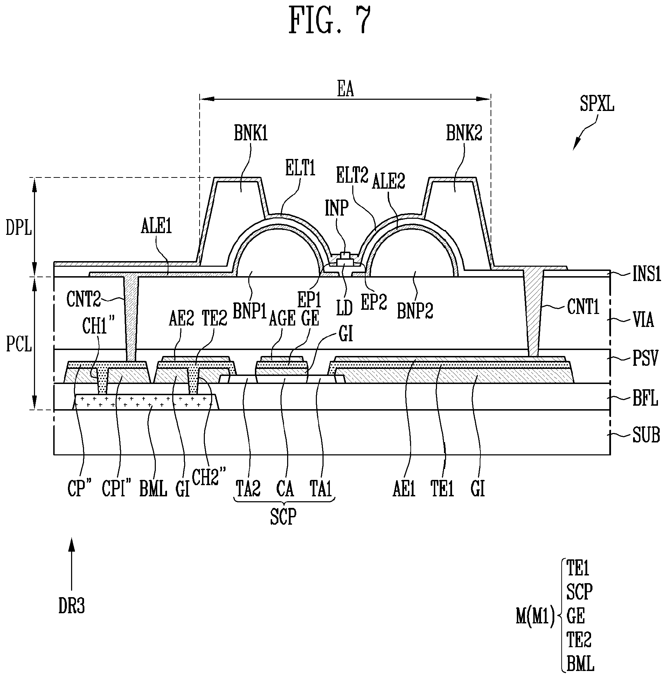

FIG. 7 is a sectional view illustrating a sub-pixel included in the display device of FIG. 1 in accordance with one or more embodiments.

Referring to FIG. 7, configurations of the display element layer DPL, other than the configuration of the first transistor M1 of the pixel circuit layer PCL, are the same as the configurations illustrated in FIGS. 3A or 5; therefore, redundant explanations of the same or corresponding components will be omitted.

Referring to FIG. 7, there are illustrated the first transistor M1 (refer to FIG. 2) and a conductive pattern CP", as examples of circuit elements that may be disposed in the pixel circuit layer PCL of FIG. 7.

In one or more embodiments illustrated in FIG. 7, because the conductive pattern CP", the first and second transistor electrodes TE1 and TE2, and the gate electrode GE are disposed in the same layer, an interlayer insulating layer (e.g., the interlayer insulating layer ILD of FIG. 3A) may be omitted.

The bottom metal layer BML may be disposed between the substrate SUB and the buffer layer BFL.

The bottom metal layer BML and the second transistor electrode TE2 of the first transistor M1 may overlap each other in the third direction DR3 with the buffer layer BFL interposed therebetween. The bottom metal layer BML may be disposed under the second transistor electrode TE2.

The bottom metal layer BML may be physically and/or electrically connected to the conductive pattern CP", which will be described below, through a contact hole CH1" formed in the buffer layer BFL.

The bottom metal layer BML may be physically and/or electrically connected to the second transistor electrode TE2, which will be described below, through a contact hole CH2" formed in the buffer layer BFL.

The semiconductor pattern SCP of the first transistor M1 may be located on the buffer layer BFL. The semiconductor pattern SCP may include a first area TA1 (or a first doped area) connected to the first transistor electrode TE1, a second area TA2 (or a second doped area) connected to the second transistor electrode TE2, and a channel area CA formed between the first area TA1 and the second area TA2.

The first area TA1 and the second area TA2 may be a semiconductor pattern doped with an impurity. The first area TA1 may contact one area of the first transistor electrode TE1. The second area TA2 may contact one area of the second transistor electrode TE2.

A gate insulating layer GI (or a first gate insulating layer) may be disposed on the semiconductor pattern SCP. The gate insulating layer GI may be partially disposed on the semiconductor pattern SCP. In one or more embodiments, the gate insulating layer GI may be disposed to overlap the channel area CA of the semiconductor pattern SCP in the third direction DR3, and may be disposed to overlap the opposite ends of the semiconductor pattern SCP. The gate insulating layer GI disposed on the opposite ends of the semiconductor pattern SCP has been illustrated in FIG. 7 as being physically separated from the gate insulating layer GI that overlaps the channel area CA, but may be integrally formed therewith. Corresponding to the first and second areas TA1 and TA2, openings may be formed in the integrally-formed gate insulating layer GI.

The gate electrode GE may be disposed on the gate insulating layer GI. The gate electrode GE may be disposed on the gate insulating layer GI and overlap the channel area CA of the semiconductor pattern SCP in the third direction DR3.

The first transistor electrode TE1 and the second transistor electrode TE2 may be provided and/or disposed on the buffer layer BFL. The first and second transistor electrodes TE1 and TE2 may be disposed on the gate insulating layer GI. The first transistor electrode TE1 and the second transistor electrode TE2 may be disposed at positions spaced from each other. The first transistor electrode TE1 may directly contact the first area TA1 of the semiconductor pattern SCP. The second transistor electrode TE2 may directly contact the second area TA2 of the semiconductor pattern SCP.

The first and second transistor electrodes TE1 and TE2 may include titanium (Ti) and/or copper (Cu).

First and second auxiliary layers AE1 and AE2 may be disposed on the first and second transistor electrodes TE1 and TE2. A gate-electrode-auxiliary layer AGE may be disposed on the gate electrode GE. In one or more embodiments, the gate-electrode-auxiliary layer AGE may be formed through the same process as the first and second auxiliary layers AE1 and AE2, and may include the same material as the first and second auxiliary layers AE1 and AE2.

A first lower insulating layer CPI" may be disposed on the buffer layer BFL. The conductive pattern CP" may be disposed on the first lower insulating layer CPI".

In one or more embodiments, the conductive pattern CP" may be formed concurrently (e.g., simultaneously) with the first and second transistor electrodes TE1 and TE2, but embodiments of the present disclosure are not limited thereto. The conductive pattern CP" may be formed after or before the first transistor electrode TE1 and the second transistor electrode TE2 are formed.

In one or more embodiments, the conductive pattern CP", the first and second transistor electrodes TE1 and TE2, and the gate electrode GE may be disposed at the same layer.

The passivation layer PSV may be disposed on the conductive pattern CP", the first and second transistor electrodes TE1 and TE2, and the gate electrode GE. The passivation layer PSV may be disposed on the overall surface of the substrate SUB.

A via layer VIA may be disposed on the passivation layer PSV. The via layer VIA may be disposed on the overall surface of the substrate SUB. The via layer VIA may include organic material. The via layer VIA may provide a planar surface to the top.

The display element layer DPL may be located on the via layer VIA.

The first alignment electrode ALE1 disposed on the via layer VIA may be brought into contact with and/or connected with the conductive pattern CP" through a second contact hole CNT2 passing through the via layer VIA and the passivation layer PSV. The first alignment electrode ALE1 may be electrically connected to the second transistor electrode TE2 through the conductive pattern CP".

The second pixel electrode ELT2 may contact the first auxiliary layer AE1 through a first contact hole CNT1 passing through the first insulating layer INS1, via layer VIA, and the passivation layer PSV. The second pixel electrode ELT2 may be electrically connected to the first transistor electrode TE1 through the first auxiliary layer AE1.

The first auxiliary layer AE1 may be formed on the first transistor electrode TE1. The second auxiliary layer AE2 may be formed on the second transistor electrode TE2. A gate-electrode-auxiliary layer AGE may be formed on the gate electrode GE.

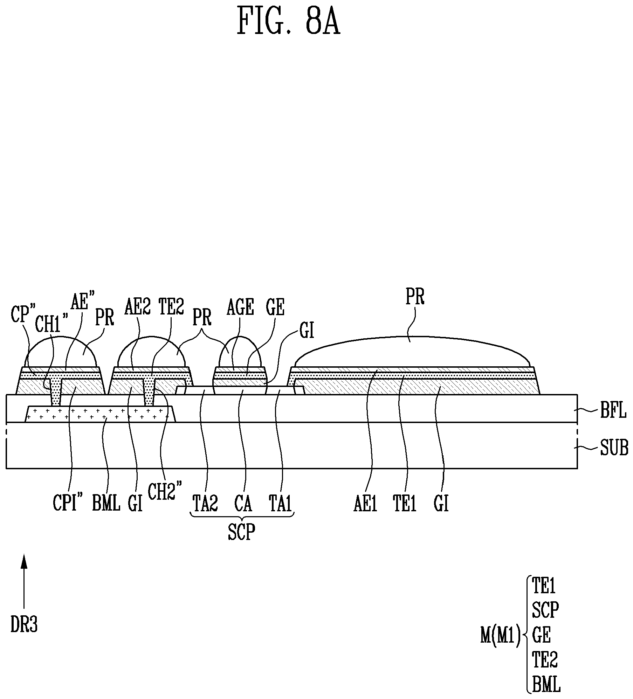

FIGS. 8A to 8E are schematic sectional views illustrating a method of fabricating a display device including the sub-pixel SPXL of FIG. 7.

Referring to FIG. 8A, the bottom metal layer BML and the buffer layer BFL may be formed on the substrate SUB. The first transistor M1 and the conductive pattern CP" may be formed on the buffer layer BFL.

After the semiconductor pattern SCP is formed on the buffer layer BFL, the first lower insulating layer CPI" and the gate insulating layer GI may be formed through the same process. The gate electrode GE and the first and second transistor electrodes TE1 and TE2 may be formed on the gate insulating layer GI. The conductive pattern CP" may be formed on the first lower insulating layer CPI".

The first auxiliary layer AE1 may be formed on the first transistor electrode TE1. The second auxiliary layer AE2 may be formed on the second transistor electrode TE2. A gate-electrode-auxiliary layer AGE may be formed on the gate electrode GE. An auxiliary layer AE" may be formed on the conductive pattern CP".

The first and second auxiliary layers AE1 and AE2, the gate-electrode-auxiliary layer AGE, and the auxiliary layer AE" may be formed through the same process.

Referring to FIG. 8A, a photoresist pattern PR may be formed on the auxiliary layer AE", the first auxiliary layer AE1, the second auxiliary layer AE2, and the gate-electrode-auxiliary layer AGE.

The photoresist pattern PR may be formed by developing a photoresist layer exposed to extreme ultraviolet rays.

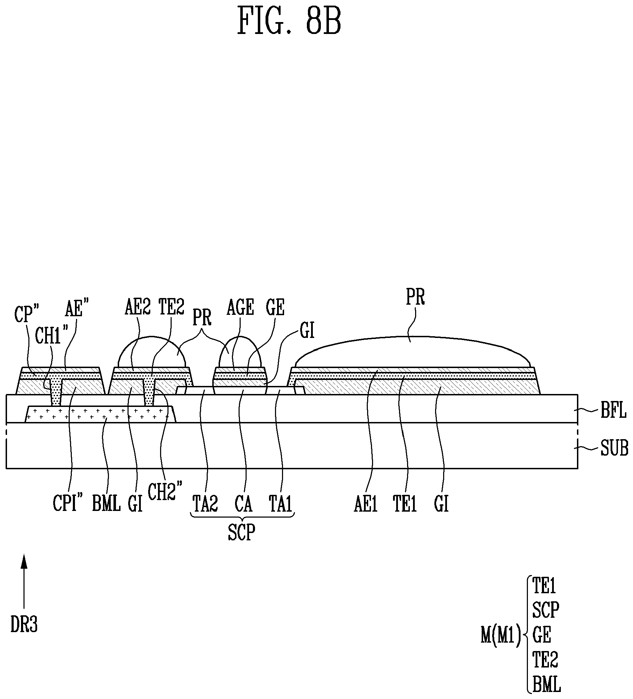

Referring to FIG. 8B, the photoresist pattern PR that is disposed on the auxiliary layer AE" may be removed. In one or more embodiments, the photoresist pattern PR that is disposed on the auxiliary layer AE" may be removed by using a halftone mask including a mask area having different transmissivity.

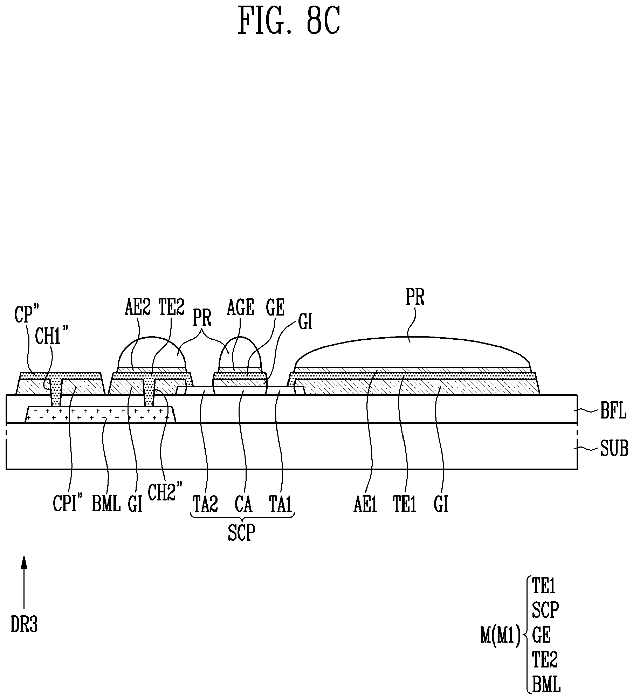

Referring to FIG. 8C, the auxiliary layer AE" that is disposed on the conductive pattern CP" may be removed. In one or more embodiments, the first auxiliary layer AE1 and the second auxiliary layer AE2 may be maintained in shape on the first transistor electrode TE1 and the second transistor electrode TE2 by the photoresist pattern, but the auxiliary layer AE" that is disposed on the conductive pattern CP" may be removed through a photolithography process.

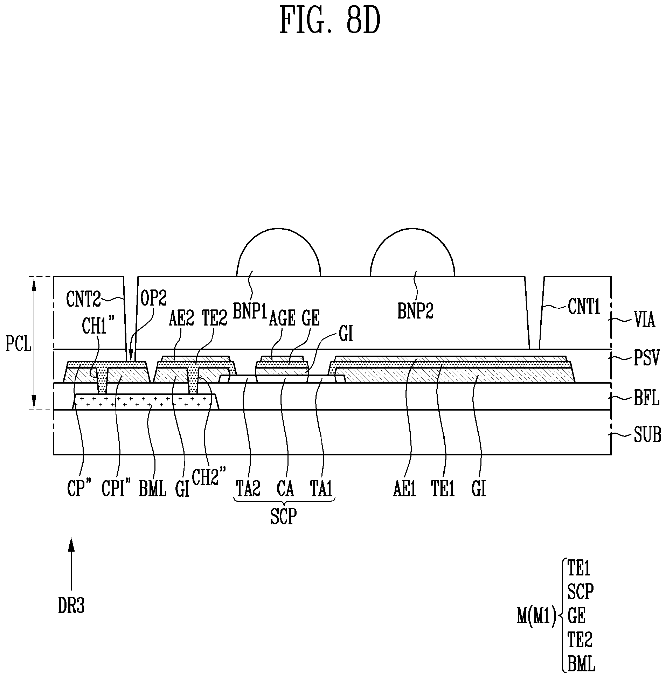

Referring to FIG. 8D, the via layer VIA may be formed on the passivation layer PSV.

Furthermore, the first contact hole CNT1 and the second contact hole CNT2 may be formed in the via layer VIA. After the via layer VIA is formed, the conductive pattern CP" may be exposed through the second contact hole CNT2 passing through the via layer VIA and the passivation layer PSV. One area of the passivation layer PSV that overlaps the conductive pattern CP" may be removed to form the second opening OP2. One area of the passivation layer PSV may be exposed through the first contact hole CNT1 passing through the via layer VIA.

During a process of forming the first contact hole CNT1, because the passivation layer PSV connected to the first contact hole CNT1 is not removed, the first auxiliary layer AE1 disposed under the passivation layer PSV may not be exposed to the outside.

The first and second bank patterns BNP1 and BNP2 may be formed on the via layer VIA. The first and second bank patterns BNP1 and BNP2 may be disposed at positions spaced from each other. The first and second bank patterns BNP1 and BNP2 may be disposed on (or at) the same layer.

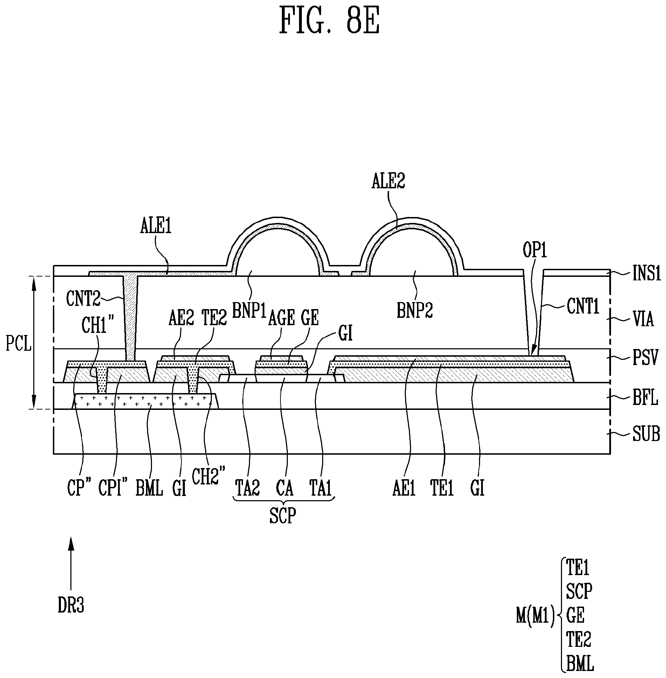

Referring to FIG. 8E, the first and second alignment electrodes ALE1 and ALE2 may be formed on the via layer VIA on which the first and second bank patterns BNP1 and BNP2 are disposed.

The first alignment electrode ALE1 may be formed to overlap the second contact hole CNT2 and the first bank pattern BNP1.

The second alignment electrode ALE2 may be formed to overlap the second bank pattern BNP2. In one or more embodiments, the second alignment electrode ALE2 may be formed not to overlap the first contact hole CNT1.

The first alignment electrode ALE1 (or the second alignment electrode ALE2) may be physically and/or electrically connected to the conductive pattern CP" through the second contact hole CNT2.

The first insulating layer INS1 may be formed on the first and second alignment electrodes ALE1 and ALE2.

Respective areas of the first insulating layer INS1 and the passivation layer PSV that correspond to the first contact hole CNT1 of the via layer VIA may be removed. In one or more embodiments, the first opening OP1 can be formed in the passivation layer PSV by removing the area of the passivation layer PSV that corresponds to the first contact hole CNT1.

The first auxiliary layer AE1 may be exposed through the first opening OP1 and the first contact hole CNT1.

A sectional view illustrating a processing step to be performed after the first opening OP1 is formed may correspond to FIG. 7.

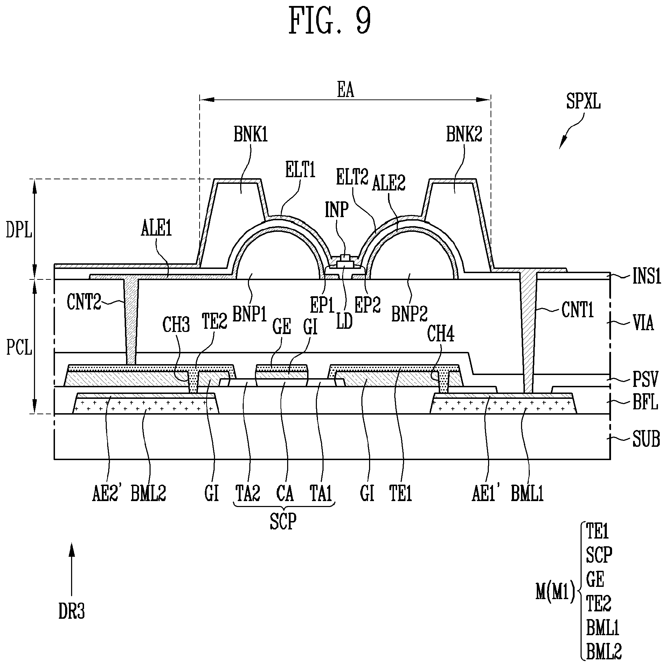

FIG. 9 is a sectional view illustrating a sub-pixel SPXL included in the display device of FIG. 1 in accordance with one or more embodiments.

Referring to FIG. 9, configurations of a display element layer DPL, other than circuit configurations of a pixel circuit layer PCL, are the same as the configurations illustrated in FIGS. 3A, 5, or 7; therefore, redundant explanations of the same or corresponding components will be omitted.

Referring to FIG. 9, the sub-pixel SPXL (or the display device) may include a pixel circuit layer PCL and a display element layer DPL that are disposed on the substrate SUB.

The pixel circuit layer PCL may include a first transistor M1, and a plurality of insulating layers BFL, GI, PSV, and VIA. The first transistor M1 may include first and second bottom metal layers BML1 and BML2, a semiconductor pattern SCP, a gate electrode GE, a first transistor electrode TE1, and a second transistor electrodes TE2.

The first and second bottom metal layers BML1 and BML2 may be disposed between the substrate SUB and the buffer layer BFL. The first and second bottom metal layers BML1 and BML2 may be disposed at positions spaced from each other. The first bottom metal layer BML1 may be disposed on the right side of the semiconductor pattern SCP, which will be described below. The second bottom metal layer BML2 may be disposed on the left side of the semiconductor pattern SCP.

The first and second bottom metal layers BML1 and BML2 may include titanium (Ti) and copper (Cu), but are not limited thereto. For example, the first and second bottom metal layers BML1 and BML2 may include one or more metallic materials selected from among silver (Ag), magnesium (Mg), aluminum (Al), platinum (Pt), palladium (Pd), gold (Au), nickel (Ni), neodymium (Nd), iridium (Ir), chrome (Cr), titanium (Ti), molybdenum (Mo), copper (Cu), etc., and/or an alloy thereof.

A first auxiliary layer AE1' may be disposed on the first bottom metal layer BML1. A second auxiliary layer AE2' may be disposed on the second bottom metal layer BML2.

The first auxiliary layer AE1' may contact the first transistor electrode TE1 through a contact hole CH4. The first bottom metal layer BML1 may be electrically connected with the first transistor electrode TE1 through the first auxiliary layer AE1'. The second auxiliary layer AE2' may contact the second transistor electrode TE2 through a contact hole CH3. The second bottom metal layer BML2 may be electrically connected with the second transistor electrode TE2 through the second auxiliary layer AE2'.

The first bottom metal layer BML1 may contact the second pixel electrode ELT2 through a first contact hole CNT1. The second pixel electrode ELT2 may be electrically connected with the first transistor electrode TE1 through the first bottom metal layer BML1. In the case where the second pixel electrode ELT2 (or the first pixel electrode ELT1) is directly connected to the first bottom metal layer BML1, contact resistance between the second pixel electrode ELT2 and the first bottom metal layer BML1 is relatively large. Thus, a defect resulting from the contact resistance may be caused. Therefore, the second pixel electrode ELT2 (or the first pixel electrode ELT1) may be connected to the first bottom metal layer BML1 through the first auxiliary layer AE1', whereby the contact resistance can be reduced.

The first and second transistor electrodes TE1 and TE2 and the gate electrode GE may be formed on the buffer layer BFL. In one or more embodiments, the first and second transistor electrodes TE1 and TE2 and the gate electrode GE may be formed in (or at) the same layer.

The second transistor electrode TE2 may contact the first alignment electrode ALE1 through a second contact hole CNT2.

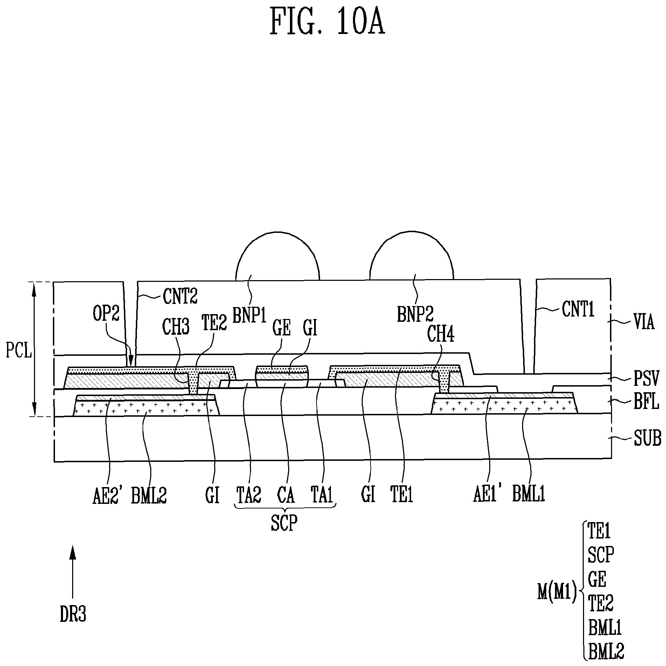

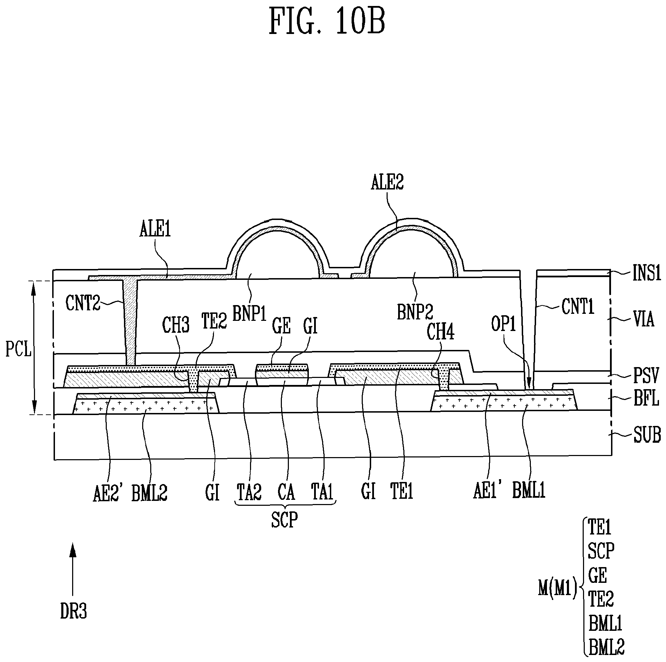

FIGS. 10A and 10B are schematic sectional views illustrating a method of fabricating a display device including the sub-pixel SPXL of FIG. 9.

Referring to FIG. 10A, the first and second bottom metal layer BML1 and BML2 and the buffer layer BFL may be formed on the substrate SUB.

The first and second bottom metal layers BML1 and BML2 may be formed between the substrate SUB and the buffer layer BFL. The first and second bottom metal layers BML1 and BML2 may be formed through the same process, but are not limited thereto.

The first auxiliary layer AE1' may be formed on the first bottom metal layer BML1. The second auxiliary layer AE2' may be formed on the second bottom metal layer BML2. In one or more embodiments, the first and second auxiliary layers AE1' and AE2' may include indium tin oxide (ITO).

The first transistor M1 may be formed on the buffer layer BFL. In one or more embodiments, the first and second transistor electrodes TE1 and TE2 and the gate electrode GE may have the same material. The first and second transistor electrodes TE1 and TE2 and the gate electrode GE may be formed in the same layer.

The passivation layer PSV and the via layer VIA may be successively formed on the buffer layer BFL.

The first contact hole CNT1 and the second contact hole CNT2 may be formed in the via layer VIA. After the via layer VIA is formed, the second transistor electrode TE2 may be exposed through the second contact hole CNT2 passing through the via layer VIA and the passivation layer PSV. One area of the passivation layer PSV that overlaps the second transistor electrode TE2 may be removed to form the second opening OP2. One area of the passivation layer PSV may be exposed through the first contact hole CNT1 passing through the via layer VIA.

During a process of forming the first contact hole CNT1, because the passivation layer PSV connected to the first contact hole CNT1 is not removed, the first auxiliary layer AE1' disposed under the passivation layer PSV may not be exposed to the outside.

The first and second bank patterns BNP1 and BNP2 may be formed on the via layer VIA. The first and second bank patterns BNP1 and BNP2 may be formed at positions spaced from each other.

Referring to FIG. 10B, the first and second alignment electrodes ALE1 and ALE2 may be formed on the via layer VIA on which the first and second bank patterns BNP1 and BNP2 are disposed.

The first alignment electrode ALE1 may be formed to overlap the second contact hole CNT2 and the first bank pattern BNP1. The second alignment electrode ALE2 may be formed to overlap the second bank pattern BNP2. In one or more embodiments, the second alignment electrode ALE2 may be formed not to overlap the first contact hole CNT1.

The first alignment electrode ALE1 (or the second alignment electrode ALE2) may contact the second transistor electrode TE2 through the second contact hole CNT2.

The first insulating layer INS1 may be formed on the first and second alignment electrodes ALE1 and ALE2.

Respective areas of the first insulating layer INS1 and the passivation layer PSV that correspond to the first contact hole CNT1 of the via layer VIA may be removed. In one or more embodiments, the first opening OP1 can be formed in the passivation layer PSV by removing the area of the passivation layer PSV that corresponds to the first contact hole CNT1.

The first auxiliary layer AE1' may be exposed through the first opening OP1 and the first contact hole CNT1.

A sectional view illustrating a processing step to be performed after the first opening OP1 is formed may correspond to FIG. 9.

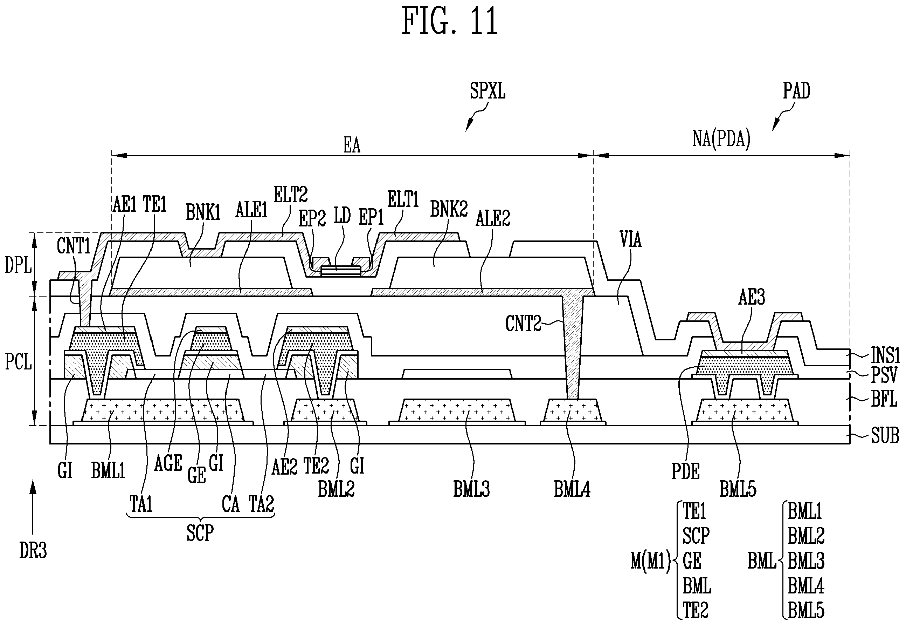

FIG. 11 is a sectional view illustrating a sub-pixel SPXL and a pad PAD that are included in the display device of FIG. 1 in accordance with one or more embodiments.

The pixel circuit layer PCL may include a first transistor M1, and a plurality of insulating layers BFL, GI, PSV, and VIA. The first transistor M1 may include a semiconductor pattern SCP, a gate electrode GE, first and second transistor electrodes TE1 and TE2, and a bottom metal layer BML.

At least one bottom metal layer BML may be disposed between the substrate SUB and the buffer layer BFL.

The bottom metal layer BML may include first to fifth bottom metal layers BML1 to BML5. The first to fifth bottom metal layers BML1 to BML5 may be disposed to be spaced from each other between the substrate SUB and the buffer layer BFL. The bottom metal layer BML may include conductive material. The conductive material may include at least one metal of various metallic materials or an alloy thereof.

The first bottom metal layer BML1 may be disposed under the first transistor electrode TE1 and the semiconductor pattern SCP. The first bottom metal layer BML1 may overlap the first transistor electrode TE1 and the semiconductor pattern SCP in the third direction DR3. The first bottom metal layer BML1 may be physically and/or electrically connected to the first transistor electrode TE1 through a contact hole .

In one or more embodiments, in FIGS. 11-12, an insulation layer may be present between the bottom metal layers (e.g., BML1, BML2, BML3, BML4) and the substrate SUB. Further, in one or more embodiments, in FIGS. 11-12, an insulation layer may be present between gate insulating layer GI and the first and second transistor electrodes TE1 and TE2 and the gate electrode GE.

The second bottom metal layer BML2 may be disposed under the second transistor electrode TE2. The second bottom metal layer BML2 may overlap the second transistor electrode TE2 in the third direction DR3. The second bottom metal layer BML2 may be physically and/or electrically connected to the second transistor electrode TE2 through a contact hole.

The third and fourth bottom metal layers BML3 and BML4 may be successively disposed on the right side of the second bottom metal layer BML2.

The fourth bottom metal layer BML4 may be physically and/or electrically connected to the second alignment electrode ALE2 through a second contact hole CNT2. The second contact hole CNT2 may pass through the via layer VIA, the passivation layer PSV, and the buffer layer BFL. The fourth bottom metal layer BML4 may be physically separated from the first transistor M1.

The fifth bottom metal layer BML5 may be disposed in the pad area PDA. The fifth bottom metal layer BML5 may overlap the pad electrode PDE in the third direction DR3. The fifth bottom metal layer BML5 may be physically and/or electrically connected to the pad electrode PDE through at least one contact hole.

The buffer layer BFL may be located on the substrate SUB and cover the bottom metal electrode BML.

The buffer layer BFL may include inorganic insulating material.

The first and second transistor electrodes TE1 and TE2, the gate electrode GE, and the semiconductor pattern SCP of the first transistor M1 may be located on the buffer layer BFL.

The gate insulating layer GI may be disposed on the buffer layer BFL.

The first and second transistor electrodes TET1 and TET2 and the gate electrode GE may be disposed on the gate insulating layer GI. The first and second transistor electrodes TE1 and TE2 and the gate electrode GE may include the same material. In one or more embodiments, the first and second transistor electrodes TE1 and TE2 and the gate electrode GE may include titanium (Ti) and copper (Cu).

First and second auxiliary layers AE1 and AE2 may be disposed on the first and second transistor electrodes TE1 and TE2. A gate-electrode-auxiliary layer AGE may be disposed on the gate electrode GE. The first and second auxiliary layers AE1 and AE2 and the gate-electrode-auxiliary layer AGE may include indium tin oxide (ITO).

The first transistor electrode TE1 may be electrically connected with a second pixel electrode ELT2, which will be described below, through the first auxiliary layer AE1. The second pixel electrode ELT2 may contact the first auxiliary layer AE1 through a first contact hole CNT1, passing through the first insulating layer INS1, via layer VIA, and the passivation layer PSV.

The passivation layer PSV may be disposed over the circuit elements including the first transistor M1.

A via layer VIA may be disposed on the passivation layer PSV. The display element layer DPL may be located on the via layer VIA.

The display element layer DPL may include first and second alignment electrodes ALE1 and ALE2, first and second banks BNK1 and BNK2, first and second pixel electrodes ELT1 and ELT2, and a first insulating layer INS1.

The first and second alignment electrodes ALE1 and ALE2 may be disposed on the via layer VIA.

The first and second banks BNK1 and BNK2 may be disposed on the first and second alignment electrodes ALE1 and ALE2. Each of the first and second banks BNK1 and BNK2 may have a shape which is reduced in width from one surface of a corresponding one of the first and second alignment electrodes ALE1 and ALE2 upward in the third direction DR3.

The first insulating layer INS1 may be partially disposed on the first and second banks BNK1 and BNK2. The first insulating layer INS1 may be disposed and/or formed on the first and second alignment electrodes ALE1 and ALE2. The first insulating layer INS1 may be disposed between the first alignment electrode ALE1 and the second alignment electrode ALE2, thus preventing a short circuit from occurring between the first alignment electrode ALE1 and the second alignment electrode ALE2. The first insulating layer INS1 may include inorganic material or organic material.

The light emitting element LD may be disposed on the first insulating layer INS1. The light emitting element LD may be an inorganic light emitting diode. The light emitting element LD may be aligned between the first alignment electrode ALE1 and the second alignment electrode ALE2 such that a first end EP1 of the light emitting element LD faces the second alignment electrode ALE2, and a second end EP2 thereof faces the first alignment electrode ALE1.

The first end EP1 of the light emitting element LD may partially overlap the second alignment electrode ALE2 in the third direction DR3. The second end EP2 of the light emitting element LD may partially overlap the first alignment electrode ALE1 in the third direction DR3. However, embodiments of the present disclosure are not limited to the foregoing.

The first pixel electrode ELT1 may be disposed on the first insulating layer INS1 and overlap the second bank BNK2 and the second alignment electrode ALE2. The first pixel electrode ELT1 may directly contact the first end EP1 of the light emitting element LD.

The second pixel electrode ELT2 may be disposed on the first insulating layer INS1 and overlap the first bank BNK1 and the first alignment electrode ALE1. The second pixel electrode ELT2 may directly contact the second end EP2 of the light emitting element LD.

The second pixel electrode ELT2 may contact the first auxiliary layer AE1 through the first contact hole CNT1 passing through the first insulating layer INS1, the via layer VIA, and the passivation layer PSV. The second pixel electrode ELT2 may be electrically connected with the first transistor electrode TE1 through the first auxiliary layer AE1.

Referring to FIGS. 1 and 11, the pad PAD may be disposed in the pad area PDA.

The pad electrode PDE may be disposed on the buffer layer BFL. The pad electrode PDE may be formed of the same conductive layer as the first and second transistor electrodes TE1 and TE2. A third auxiliary layer AE3 may be disposed on the pad electrode PDE. The pad electrode PDE may be electrically connected to another electrode (e.g., an electrode having transparent conductive material) through the third auxiliary layer AE3.

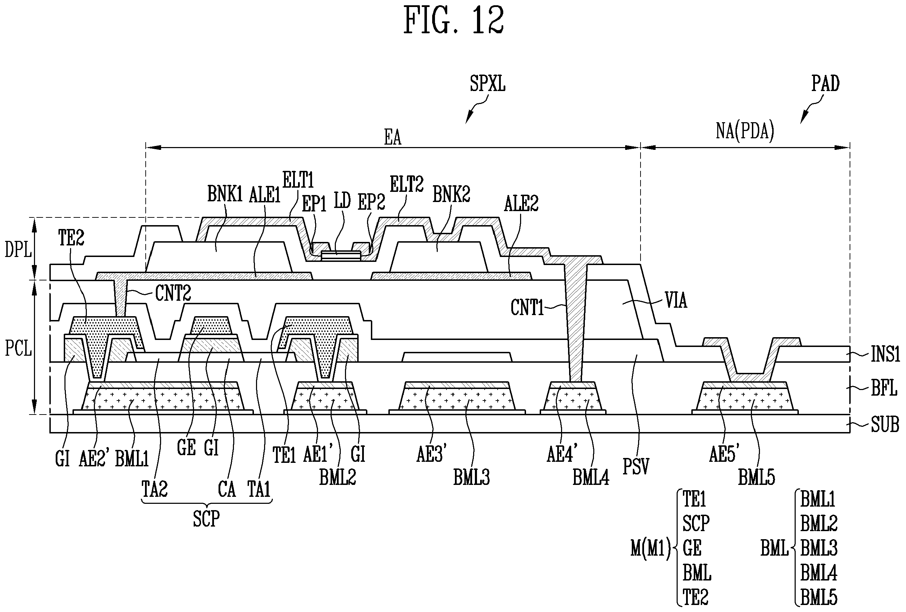

FIG. 12 is a sectional view illustrating a sub-pixel and a pad that are included in the display device of FIG. 1 in accordance with one or more embodiments.

Referring to FIG. 12, except auxiliary layers AE1' to AE5' and first and second pixel electrodes ELT1 and ELT2 of the display element layer DPL, the other configurations are the same as the configurations illustrated in FIG. 11; therefore, redundant explanation of the same or corresponding components will be omitted.

The auxiliary layers AE1' to AE5' may be disposed on the first to fifth bottom metal layers BML1 to BML5.

The second auxiliary layer AE2' may be disposed on the first bottom metal layer BML1.

The second auxiliary layer AE2' may physically and/or electrically contact the second transistor electrode TE2 through a contact hole. The first bottom metal layer BML1 may be electrically connected to the second transistor electrode TE2 through the second auxiliary layer AE2'.

The first auxiliary layer AE1' may be disposed on the second bottom metal layer BML2.

The first auxiliary layer AE1' may be physically and/or electrically connected to the first transistor electrode TE1 through a contact hole. The second bottom metal layer BML2 may be electrically connected with the first transistor electrode TE1 through the first auxiliary layer AE1'.

The third auxiliary layer AE3' may be disposed on the third bottom metal layer BML3.

The fourth auxiliary layer AE4' may be disposed on the fourth bottom metal layer BML4. The fourth auxiliary layer AE4' may contact the second pixel electrode ELT2 through a first contact hole CNT1. The fourth bottom metal layer BML4 may be electrically connected to the second pixel electrode ELT2 through the fourth auxiliary layer AE4'.

The fifth bottom metal layer BML5 may be disposed in the pad area PDA. The fifth auxiliary layer AE5' may be disposed on the fifth bottom metal layer BML5.

The first to fifth auxiliary layers AE1' to AE5' may be formed through the same process, and may include the same material, but are not limited thereto. The first to fifth auxiliary layers AE1' to AE5' may be successively formed.

The second pixel electrode ELT2 (or the first pixel electrode ELT1) may be connected to the circuit elements of the pixel circuit layer PCL through the fourth auxiliary layer AE4'. Because the second pixel electrode ELT2 (or the first pixel electrode ELT1) are electrically connected to other electrodes through the fourth auxiliary layer AE4', contact resistance between the second pixel electrode ELT2 (or the first pixel electrode ELT1) and the other electrodes can be reduced.

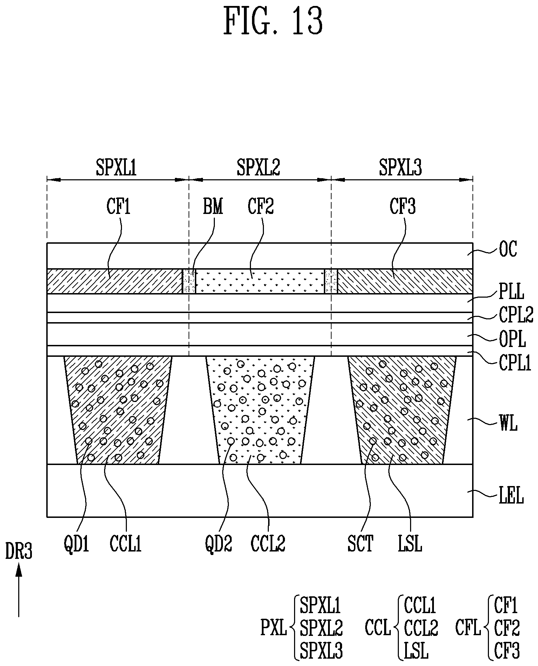

FIG. 13 is a sectional view illustrating first to third sub-pixels SPXL1 to SPXL3 of FIG. 1.

FIG. 13 illustrates a partition wall WL, a color conversion layer CCL, and/or a color filter layer CFL that are provided on the light-emitting-element layer LEL of the sub-pixel SPXL of FIG. 1.

The light-emitting-element layer LEL may be disposed on the display element layer DPL.

Referring to FIG. 13, the partition wall WL may be disposed on the light-emitting-element layer LEL for the first to third sub-pixels SPXL1 to SPXL3. For example, the partition wall WL may be disposed between the first to third sub-pixels SPXL1 to SPXL3 or on boundaries therebetween, and include openings that respectively overlap the first to third sub-pixels SPXL1 to SPXL3. The openings of the partition wall WL may provide space in which the color conversion layer CCL can be provided.

The partition wall WL may include organic material such as acrylic resin, epoxy resin, phenolic resin, polyamide resin, polyimide resin, polyester resin, polyphenylene sulfide resin, and/or benzocyclobutene (BCB). However, embodiments of the present disclosure are not limited thereto. The partition wall WL may include one or more selected from among various inorganic materials such as, for example, silicon oxide (SiOₓ), silicon nitride (SiNₓ), silicon oxynitride (SiOₓN_{y}), aluminum nitride (AlNₓ), aluminum oxide (AlOₓ), zirconium oxide (ZrOₓ), hafnium oxide (HfOₓ), and/or titanium oxide (TiOₓ).

The partition wall WL may include at least one light shielding and/or reflective material. Therefore, a light leakage between adjacent sub-pixels SPXL may be prevented from being caused. For example, the partition wall WL may include at least one black matrix material and/or color filter material. For instance, the partition wall WL may be formed of a black opaque pattern that can block transmission of light. In one or more embodiments, a reflective layer or the like may be formed on a surface (e.g., a sidewall) of the partition wall WL to increase the light efficiency of each pixel PXL.

The color conversion layer CCL may be disposed on the light emitting element layer LEL including the light emitting elements LD in the openings of the partition wall WL. The color conversion layer CCL may include a first color conversion layer CCL1 disposed in the first sub-pixel SPXL1, a second color conversion layer CCL2 disposed in the second sub-pixel SPXL2, and a light scattering layer LSL disposed in the third sub-pixel SPXL3.

The first to third sub-pixels SPXL1 to SPXL3 may include light emitting elements LD configured to emit the same color of light. For example, the first to third sub-pixels SPXL1 to SPXL3 may include light emitting elements LD configured to emit the third color of light (or blue light). Because the color conversion layer CCL including color conversion particles is disposed in each of the first to third sub-pixels SPXL1 to SPXL3, a full-color image may be displayed.

The first color conversion layer CCL1 may include first color conversion particles for converting the third color of light emitted from the light emitting element LD to the first color of light. For example, the first color conversion layer CCL1 may include a plurality of first quantum dots QD1 that are diffused in a matrix material such as base resin.

In the case where the light emitting element LD is a blue light emitting element configured to emit blue light and the first pixel PXL1 or the first sub-pixel SPXL1 is a red pixel, the first color conversion layer CCL1 may include the first quantum dots QD1 that convert blue light emitted from the blue light emitting element to red light. The first quantum dots QD1 may absorb blue light, shift the wavelength thereof according to an energy transition, and thus emit red light. In the case where the first pixel PXL1 or the first sub-pixel SPXL1 is a pixel of a different color, the first color conversion layer CCL1 may include the first quantum dots QD1 corresponding to the color of the first pixel PXL1 or the first sub-pixel SPXL1.

The second color conversion layer CCL2 may include second color conversion particles for converting the third color of light emitted from the light emitting element LD to the second color of light. For example, the second color conversion layer CCL2 may include a plurality of second quantum dots QD2 that are dispersed in a matrix material such as base resin.

In the case where the light emitting element LD is a blue light emitting element configured to emit blue light and the second pixel PXL2 or the second sub-pixel SPXL2 is a green pixel, the second color conversion layer CCL2 may include the second quantum dots QD2 that convert blue light emitted from the blue light emitting element to green light. The second quantum dots QD2 may absorb blue light, shift the wavelength thereof according to an energy transition, and thus emit green light. In case that the second color pixel PXL2 or the second color sub-pixel SPXL2 is a pixel of a different color, the second color conversion layer CCL2 may include the second quantum dots QD2 corresponding to the color of the second pixel PXL2 or the second sub-pixel SPXL2.

As blue light having a relatively short wavelength in a visible ray area is incident on each of the first quantum dots QD1 and the second quantum dots QD2, absorption coefficients of the first quantum dot QD1 and the second quantum dot QD2 may be increased. Therefore, eventually, the efficiency of light emitted from the first sub-pixel SPXL1 and the second sub-pixel SPXL2 may be enhanced, and satisfactory color reproducibility may be secured. Furthermore, because the emission component EMU for the first to third sub-pixels SPXL1 to SPXL3 is formed of light emitting elements LD (e.g., blue light emitting elements) configured to emit the same color of light, the efficiency of fabricating the display device may be enhanced.

The light scattering layer LSL may be provided to efficiently use the third color of light (or blue light) emitted from the light emitting element LD. For example, in the case where the light emitting element LD is a blue light emitting element configured to emit blue light and the third sub-pixel SPXL3 is a blue pixel, the light scattering layer LSL may include at least one type of light scatterer SCT to efficiently use light emitted from the light emitting element LD.

For example, the light scattering layer LSL may include a plurality of light scatterers SCT that are diffused in a matrix material such as base resin. For instance, the light scattering layer LSL may include light scatterers SCT formed of material such as silica, but the constituent material of the light scatterers SCT is not limited thereto. The light scatterers SCT may not only be provided in the third sub-pixel SPXL3, but may also be selectively included in the first color conversion layer CCL1 or the second color conversion layer CCL2. In one or more embodiments, the light scatterers SCT may be omitted, and the light scattering layer LSL may be formed of transparent polymer.

A first capping layer CPL1 may be disposed on the color conversion layer CCL. The first capping layer CPL1 may be provided over the first to third sub-pixels SPXL1 to SPXL3. The first capping layer CPL1 may cover the color conversion layer CCL. The first capping layer CPL1 may prevent the color conversion layer CCL from being damaged or contaminated by permeation of external impurities such as water or air.

The first capping layer CPL1 may be an inorganic layer, and may be formed of one or more selected from among silicon nitride (SiNₓ), aluminum nitride (AlNₓ), titanium nitride (TiNx), silicon oxide (SiOₓ), aluminum oxide (AlOₓ), titanium oxide (TiOₓ), silicon oxycarbide (SiOₓC_{y}), and/or silicon oxynitride (SiOₓN_{y}).

The optical layer OPL may be disposed on the first capping layer CPL1. The optical layer OPL may function to recycle light provided from the color conversion layer CCL by total reflection and thus enhance light extraction efficiency. Hence, the optical layer OPL may have a relatively low refractive index compared to that of the color conversion layer CCL. For example, the refractive index of the color conversion layer CCL may approximately range from 1.6 to 2.0, and the refractive index of the optical layer OPL may approximately range from 1.1 to 1.3.

A second capping layer CPL2 may be disposed on the optical layer OPL. The second capping layer CPL2 may be provided over the first to third sub-pixels SPXL1 to SPXL3. The second capping layer CPL2 may cover the optical layer OPL. The second capping layer CPL2 may prevent the optical layer OPL from being damaged or contaminated by permeation of external impurities such as water or air.

The second capping layer CPL2 may include inorganic material.

A planarization layer PLL may be disposed on the second capping layer CPL2. The planarization layer PLL may be provided over the first to third sub-pixels SPXL1 to SPXL3.

The planarization layer PLL may include organic material such as acrylic resin, epoxy resin, phenolic resin, polyamide resin, polyimide resin, polyester resin, polyphenylene sulfide resin, and/or benzocyclobutene (BCB). However, embodiments of the present disclosure are not limited thereto, and the planarization layer PLL may include various types of inorganic materials.

The color filter layer CFL may be disposed on the planarization layer PLL. The color filter layer CFL may include color filters CF1, CF2, and CF3 corresponding to the colors of the respective sub-pixels SPXL. Because the color filters CF1, CF2, and CF3 corresponding to the respective colors of the first to third sub-pixels SPXL1 to SPXL3 are disposed, a full-color image may be displayed.

The color filter layer CFL may include a first color filter CF1 disposed in the first sub-pixel SPXL1 and configured to allow light emitted from the first sub-pixel SPXL1 to selectively pass therethrough, a second color filter CF2 disposed in the second sub-pixel SPXL2 and configured to allow light emitted from the second sub-pixel SPXL2 to selectively pass therethrough, and a third color filter CF3 disposed in the third sub-pixel SPXL3 and configured to allow light emitted from the third sub-pixel SPXL3 to selectively pass therethrough.

In one or more embodiments, the first color filter CF1, the second color filter CF2, and the third color filter CF3 may be respectively a red color filter, a green color filter, and a blue color filter, but embodiments of the present disclosure are not limited thereto. Hereinafter, the term "color filter CF" or "color filters CF" will be used to designate a color filter from among the first color filter CF1, the second color filter CF2, and the third color filter CF3, or collectively designate two or more kinds of color filters.

The first color filter CF1 may overlap the light emitting element layer LEL (or the light emitting elements LD) and the first color conversion layer CCL1 of the first sub-pixel SPXL1 in the third direction DR3 (the Z-axis direction). The first color filter CF1 may include color filter material for allowing the first color of light (or red light) to selectively pass therethrough. For example, in the case in which the first sub-pixel SPXL1 is a red pixel, the first color filter CF1 may include red color filter material.

The second color filter CF2 may overlap the light emitting element layer LEL (or the light emitting element LD) and the second color conversion layer CCL2 of the second sub-pixel SPXL2 in the third direction DR3. The second color filter CF2 may include color filter material for allowing the second color of light (or green light) to selectively pass therethrough. For example, in the case in which the second sub-pixel SPXL2 is a green pixel, the second color filter CF2 may include green color filter material.

The third color filter CF3 may overlap the light emitting element layer LEL (or the light emitting element LD) and the light scattering layer LSL of the third sub-pixel SPXL3 in the third direction DR3. The third color filter CF3 may include color filter material for allowing the third color of light (or blue light) to selectively pass therethrough. For example, in the case in which the third sub-pixel SPXL3 is a blue pixel, the third color filter CF3 may include blue color filter material.

In one or more embodiments, a light shielding layer BM may be further disposed between the first to third color filters CF1, CF2, and CF3. In the case where the light shielding layer BM is formed between the first to third color filters CF1, CF2, and CF3, a color mixing defect that is visible from a front surface or side surface of the display device may be prevented from occurring. The material of the light shielding layer BM is not particularly limited, and various light shielding materials may be used to form the light shielding layer BM. For example, the light shielding layer BM may be embodied by stacking the first to third color filters CF1, CF2, and CF3 one on another.

An overcoat layer OC may be disposed on the color filter layer CFL. The overcoat layer OC may be provided over the first to third sub-pixels SPXL1 to SPXL3. The overcoat layer OC may cover a lower component including the color filter layer CFL. The overcoat layer OC may prevent water or air from permeating the lower component. Furthermore, the overcoat layer OC may protect the lower component from foreign material such as dust.

The overcoat layer OC may include organic material. However, embodiments of the present disclosure are not limited thereto, and the overcoat layer OC may include various types of inorganic materials.

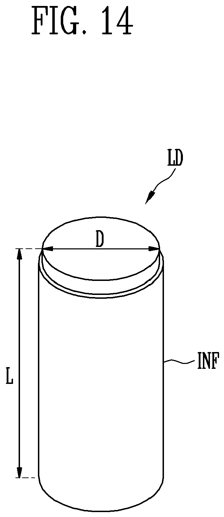

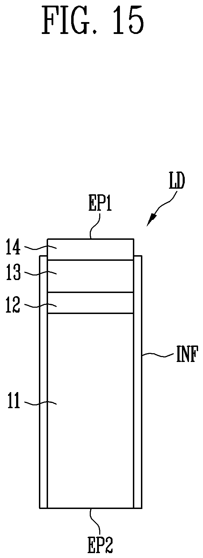

FIGS. 14 and 15 are diagrams each illustrating a light emitting element in accordance with one or more embodiments.

Referring to FIGS. 14 and 15, the light emitting element LD may include a first semiconductor layer 11, a second semiconductor layer 13, and an active layer 12 interposed between the first and second semiconductor layers 11 and 13. For example, the light emitting element LD may be implemented as an emission stack (or referred to as "stacked pattern") formed by successively stacking the first semiconductor layer 11, the active layer 12, and the second semiconductor layer 13.

The light emitting element LD may be formed in a shape extending in one direction. If the direction in which the light emitting element LD extends is defined as a longitudinal direction, the light emitting element LD may have a first end EP1 and a second end EP2 with respect to the longitudinal direction. One semiconductor layer of the first semiconductor layer 11 and the second semiconductor layer 13 may be disposed on the first end EP1 of the light emitting element LD, and the other semiconductor layer of the first semiconductor layer 11 and the second semiconductor layer 13 may be disposed on the second end EP2 of the light emitting element LD.

The light emitting element LD may be provided in various shapes. For example, as illustrated in FIGS. 14-15, the light emitting element LD may have a rod-like shape, a bar-like shape, or a pillar-like shape that is long with respect to the longitudinal direction (i.e., to have an aspect ratio greater than 1). Alternatively, the light emitting element LD may have a rod-like shape, a bar-like shape, or a pillar-like shape that is short with respect to the longitudinal direction (or has an aspect ratio less than 1). As a further alternative, the light emitting element LD may have a rod-like shape, a bar-like shape, or a pillar-like shape having an aspect ratio of 1.

The light emitting element LD may include a light emitting diode (LED) fabricated to have a subminiature size, e.g., with a diameter D and/or a length L corresponding to a range from the nano scale (or the nanometer scale) to the micro scale (or the micrometer scale).

In case that the light emitting element LD is long (i.e., to have an aspect ratio greater than 1) with respect to the longitudinal direction, the diameter D of the light emitting element LD may approximately range from 0.5 µm to 6 µm, and the length L thereof may approximately range from 1 µm to 10 µm. However, the diameter D and the length L of the light emitting element LD are not limited thereto. The size of the light emitting element LD may be changed to meet requirements (or design conditions) of a lighting device or a self-emissive display device to which the light emitting element LD is applied.

The first semiconductor layer 11 may include, for example, at least one n-type semiconductor layer. The first semiconductor layer 11 may include, with respect to the longitudinal direction of the light emitting element LD, an upper surface that contacts the active layer 12, and a lower surface exposed to the outside. The lower surface of the first semiconductor layer 11 may correspond to one end (or a lower end) EP2 of the light emitting element LD.

The active layer 12 may be disposed on the first semiconductor layer 11 and have a single or multi-quantum well structure. For example, in case that the active layer 12 is formed to have a multi-quantum well structure, the active layer 12 may be formed by periodically repeatedly stacking a barrier layer, a stain reinforcing layer, and/or a well layer that are provided as one unit. The stain reinforcing layer may have a lattice constant less than that of the barrier layer so that resistance to strain, e.g., compressive strain, to be applied to the well layer can be further reinforced. However, the structure of the active layer 12 is not limited to that of the foregoing embodiment.

The active layer 12 may emit light having a wavelength approximately ranging from 400 nm to 900 nm, and have a double hetero structure. The active layer 12 may include a first surface that contacts the first semiconductor layer 11, and a second surface which contacts the second semiconductor layer 13.

Depending on the wavelength of light emitted from the active layer 12, the color (or output light color) of the light emitting element LD may be determined. The color of the light emitting element LD may determine the color of the corresponding pixel. For example, the light emitting element LD may emit red light, green light, or blue light.

If an electric field having a certain voltage or more is applied between the opposite ends of the light emitting element LD, the light emitting element LD may emit light by coupling of electron-hole pairs in the active layer 12. Because light emission of the light emitting element LD can be controlled based on the foregoing principle, the light emitting element LD may be used as a light source (a light emitting source) of various light emitting devices as well as a pixel of a display device.

The second semiconductor layer 13 may be disposed on the second surface of the active layer 12 and include a semiconductor layer of a type different from that of the first semiconductor layer 11. For example, the second semiconductor layer 13 may include at least one p-type semiconductor layer.

The second semiconductor layer 13 may include, with regard to the longitudinal direction of the light emitting element LD, a lower surface that contacts the second surface of the active layer 12, and an upper surface exposed to the outside. Here, the upper surface of the second semiconductor layer 13 may correspond to a remaining end (or an upper end or EP1) of the light emitting element LD.

The first semiconductor layer 11 and the second semiconductor layer 13 may have different thicknesses with respect to the longitudinal direction of the light emitting element LD. For example, the first semiconductor layer 11 may have a thickness greater than that of the second semiconductor layer 13 with respect to the longitudinal direction of the light emitting element LD. Hence, the active layer 12 of the light emitting element LD may be disposed at a position closer to the upper surface of the second semiconductor layer 13 than to the lower surface of the first semiconductor layer 11.

Although the first semiconductor layer 11 and the second semiconductor layer 13 each are formed of a single layer, embodiments of the present disclosure are not limited thereto. In one or more embodiments, depending on the material of the active layer 12, the first semiconductor layer 11 and the second semiconductor layer 13 each may further include one or more layers, for example, a clad layer and/or a tensile strain barrier reducing (TSBR) layer. The TSBR layer may be a strain relief layer that is disposed between semiconductor layers having different lattice structures and thus can function as a buffer layer to reduce a difference in lattice constant. Although the TSBR layer may be formed of a p-type semiconductor layer such as p-GalnP, p-AllnP, or p-AlGalnP, embodiments of the present disclosure are not limited thereto.

The light emitting element LD may further include a contact electrode 14 (hereinafter referred to as "first contact electrode") disposed over the second semiconductor layer 13, as well as including the first semiconductor layer 11, the active layer 12, and the second semiconductor layer 13. Furthermore, in one or more embodiments, the light emitting element LD may further include an additional contact electrode (hereinafter referred to as "second contact electrode") disposed on one end of the first semiconductor layer 11.

Each of the first and second contact electrodes may be an ohmic contact electrode, but embodiments of the present disclosure are not limited thereto. In one or more embodiments, each of the first and second contact electrodes may be a Schottky contact electrode. The first and second contact electrodes may include conductive material.

The light emitting element LD may further include an insulating layer INF(or referred to as "insulating film"). However, depending on the embodiment, the insulating layer INF may be omitted, or may be provided to cover only some of the first semiconductor layer 11, the active layer 12, and the second semiconductor layer 13.

The insulating layer INF may prevent the active layer 12 from short-circuiting due to making contact with conductive material except the first and second semiconductor layers 11 and 13. Furthermore, the insulating layer INF may reduce or minimize a surface defect of the light emitting element LD, thus enhancing the lifetime and emission efficiency of the light emitting element LD. The presence or non-presence of the insulating layer INF is not limited, so long as the active layer 12 can be prevented from short-circuiting with external conductive material.

The insulating layer INF may be provided to be around (e.g., to enclose) at least a portion of an outer surface (e.g., an outer peripheral or circumferential surface) of the emission stack including the first semiconductor layer 11, the active layer 12, and the second semiconductor layer 13.

Although in the foregoing embodiment the insulating layer INF has been described as enclosing the entirety of the outer surface (e.g., an outer peripheral or circumferential surface) of each of the first semiconductor layer 11, the active layer 12, and the second semiconductor layer 13, embodiments of the present disclosure are not limited thereto.

The insulating layer INF may include transparent insulating material. For example, the insulating layer INF may be include one or more insulating materials selected from among the group of silicon oxide (SiOₓ), silicon nitride (SiNₓ), silicon oxynitride (SiOₓN_{y}), aluminum oxide (AlOₓ), titanium oxide (TiOₓ), hafnium oxide (HfOₓ), titanstrontium oxide (SrTiOₓ), cobalt oxide (CoₓO_{y}), magnesium oxide (MgO), zinc oxide (ZnOₓ), ruthenium Oxide (RuOₓ), nickel oxide (NiO), tungsten oxide (WOₓ), tantalum oxide (TaOₓ), gadolinium oxide (GdOₓ), zirconium oxide (ZrOₓ), gallium oxide (GaOₓ), vanadium oxide (VₓO_{y}), ZnO:Al, ZnO:B, InxOy:H, niobium oxide (NbₓO_{y}), magnesium fluoride (MgFₓ), aluminum fluoride (AlFₓ), an alucone polymer film, titanium nitride (TiN), tantalum nitride (TaN), aluminum nitride (AlNₓ), gallium nitride (GaN), tungsten nitride (WN), hafnium nitride (HfN), niobium nitride (NbN), gadolinium nitride (GdN), zirconium nitride (ZrN), and/or vanadium nitride (VN). However, embodiments of the present disclosure are not limited thereto, and various materials having insulation may be used as the material of the insulating layer INF.

The insulating layer INF may have a single-layer structure or a multilayer structure including a double-layer structure.

The light emitting element LD may be employed as a light emitting source (or a light source) for various display devices. The light emitting element LD may be fabricated through a surface treatment process. For example, the light emitting element LD may be surface-treated so that, when a plurality of light emitting elements LD are mixed with a fluidic solution (or solvent) and then supplied to each pixel area (e.g., an emission area of each pixel or an emission area of each sub-pixel), the light emitting elements LD can be evenly distributed rather than unevenly aggregating in the solution.

An emission component (or a light emitting device) including the light emitting elements LD described above may be used not only in a display device but also in various types of electronic devices each of which requires a light source. For instance, in the case where a plurality of light emitting elements LD are disposed in the pixel area of each pixel of a display panel, the light emitting elements LD may be used as a light source of the pixel. However, the application field of the light emitting element LD is not limited to the above-mentioned examples. For example, the light emitting element LD may also be used in other types of electronic devices such as a lighting device, which requires a light source.

However, the foregoing is only for illustrative purposes, and the light emitting element LD in accordance with embodiments of the present disclosure is not limited thereto. For example, the light emitting element may be a flip chip type micro light emitting diode, or an organic light emitting element including an organic emission layer.

As discussed, embodiments can provide a display device comprising: a pixel circuit layer comprising a first transistor and a first auxiliary layer; and a display element layer over the pixel circuit layer, and comprising at least one light emitting element, wherein the display element layer comprises: a first pixel electrode electrically connected to a first end of the light emitting element; and a second pixel electrode electrically connected to a second end of the light emitting element, wherein the first transistor comprises: a semiconductor pattern; a first gate insulating layer over the semiconductor pattern; a gate electrode on the first gate insulating layer; and a first transistor electrode and a second transistor electrode connected to the semiconductor pattern, wherein the first transistor electrode is connected to the second pixel electrode by the first auxiliary layer, and wherein the first auxiliary layer is between the first transistor electrode and the second pixel electrode.

The first auxiliary layer may be located between first transistor electrode and the second pixel electrode, and may electrically connect the first transistor electrode and the second pixel electrode.

The first auxiliary layer may be directly on the first transistor electrode.

The first auxiliary layer may overlap the first transistor electrode in plan view.

The first transistor electrode and the second transistor electrode may comprise titanium, Ti, and/or copper, Cu. The first transistor electrode and the second transistor electrode may include an alloy comprising titanium, Ti, and/or copper, Cu.

The pixel circuit layer may further comprises a second auxiliary layer. The second auxiliary layer may be directly on the second transistor electrode. The second auxiliary layer may overlap the second transistor electrode in plan view. The first auxiliary layer and the second auxiliary layer may be at a same layer and may comprise a same material.

The display element layer may be directly on the pixel circuit.

The first gate insulating layer may be directly on the semiconductor pattern.

The gate electrode may be directly on the first gate insulating layer.

Embodiments can provide a display device comprising: a substrate; a first bottom metal layer over the substrate; a first auxiliary layer directly on the first bottom metal layer; a buffer layer covering the first bottom metal layer; a first transistor over the buffer layer; a light emitting element on the first transistor; a first pixel electrode electrically connected to a first end of the light emitting element; and a second pixel electrode electrically connected to a second end of the light emitting element, wherein the first transistor comprises a first transistor electrode and a second transistor electrode, and wherein the second pixel electrode is connected to the first bottom metal layer by the first auxiliary layer.

Embodiments can provide a display device comprising: a substrate; a first bottom metal layer over the substrate; a first auxiliary layer directly on the first bottom metal layer; a buffer layer covering the first bottom metal layer; a first transistor over the buffer layer, and comprising a first transistor electrode and a second transistor electrode; a light emitting element on the first transistor; a first pixel electrode electrically connected to a first end of the light emitting element; and a second pixel electrode electrically connected to a second end of the light emitting element, wherein the second pixel electrode is connected to the first bottom metal layer by the first auxiliary layer, and wherein the second pixel electrode directly contacts the first auxiliary layer.

In a display device in accordance with embodiments of the present disclosure, pixel electrodes (first and second pixel electrodes) connected to light emitting elements are connected to pixel circuit elements by an auxiliary layer (an ITO layer), so that contact resistance between the pixel electrodes and the pixel circuit elements can be reduced. Therefore, defects resulting from the contact resistance may be mitigated or prevented.

However, effects, aspects and features of the present disclosure are not limited to the above-described effects, aspects, and features, and various modifications are possible without departing from the scope of the present disclosure.

While embodiments of the present disclosure have been described above, those skilled in the art will appreciate that various modifications, additions and substitutions are possible, without departing from the scope of the present disclosure claimed in the appended claims.

## Claims

1. A display device comprising:
a pixel circuit layer comprising a first transistor and a first auxiliary layer; and
a display element layer on the pixel circuit layer, and comprising at least one light emitting element,
wherein the display element layer comprises:
a first pixel electrode electrically connected to a first end of the light emitting element; and
a second pixel electrode electrically connected to a second end of the light emitting element,
wherein the first transistor comprises:
a semiconductor pattern;
a first gate insulating layer on the semiconductor pattern;
a gate electrode on the first gate insulating layer; and
a first transistor electrode and a second transistor electrode connected to the semiconductor pattern,
wherein the first transistor electrode is connected to the second pixel electrode by the first auxiliary layer, and
wherein the first auxiliary layer is between the first transistor electrode and the second pixel electrode.

2. The display device according to claim 1, wherein the first auxiliary layer comprises indium tin oxide, ITO.

3. The display device according to claim 1 or 2, wherein the first auxiliary layer is directly on the first transistor electrode.

4. The display device according to any one of claims 1 to 3, wherein the first transistor electrode and the second transistor electrode comprise titanium, Ti, and/or copper, Cu.

5. The display device according to any one of claims 1 to 4,
wherein the pixel circuit layer further comprises:
a first bottom metal layer on a substrate, and electrically connected to the second transistor electrode;
a buffer layer covering the first bottom metal layer; and
a conductive pattern at a same layer as the gate electrode, and electrically connected to the first bottom metal layer,
wherein the display element layer further comprises:
a first alignment electrode under the first pixel electrode; and
a second alignment electrode under the second pixel electrode, and
wherein one alignment electrode from among the first alignment electrode and the second alignment electrode is directly connected to the conductive pattern.

6. The display device according to claim 5,
wherein the pixel circuit layer further comprises a second auxiliary layer,
wherein the second auxiliary layer is directly on the second transistor electrode, and
wherein the first auxiliary layer and the second auxiliary layer are at a same layer and comprise a same material.

7. The display device according to claim 5 or 6, wherein the first auxiliary layer is not on the conductive pattern;
optionally wherein the first transistor electrode and the second transistor electrode are in a layer different from a layer in which the gate electrode is located.

8. The display device according to any one of claims 5 to 7,
wherein the pixel circuit layer further comprises a first insulating layer on the buffer layer,
wherein the conductive pattern is on the first insulating layer, and
wherein the gate electrode and the conductive pattern are at a same layer;
optionally wherein the gate electrode, the first transistor electrode, the second transistor electrode, and the conductive pattern are at a same layer.

9. The display device according to any one of claims 1 to 8,
wherein the pixel circuit layer comprises:
a first bottom metal layer under the second transistor electrode; and
a buffer layer covering the first bottom metal layer, and
wherein the first auxiliary layer is directly on the first bottom metal layer.

10. The display device according to claim 9, wherein the first transistor electrode, the second transistor electrode, and the first bottom metal layer comprise titanium, Ti, and copper, Cu;
optionally wherein the display element layer comprises: a first alignment electrode under the first pixel electrode; and a second alignment electrode under the second pixel electrode, and wherein one alignment electrode from among the first alignment electrode and the second alignment electrode is directly connected to the second transistor electrode;
further optionally wherein the pixel circuit layer further comprises: a second bottom metal layer spaced from the first bottom metal layer; and a second auxiliary layer directly on the second bottom metal layer, and wherein the second transistor electrode is directly connected to the second auxiliary layer;
yet further optionally wherein the gate electrode, the first transistor electrode, and the second transistor electrode are at a same layer.

11. The display device according to any one of claims 1 to 8,
wherein the pixel circuit layer comprises:
a first bottom metal layer on a substrate; and
a buffer layer covering the first bottom metal layer, and
wherein the first transistor is on the buffer layer,
wherein the display element layer comprises:
a first alignment electrode under the first pixel electrode; and
a second alignment electrode under the second pixel electrode, and
wherein one alignment electrode from among the first alignment electrode and the second alignment electrode is directly connected to the first bottom metal layer through a contact hole.

12. A display device comprising:
a substrate;
a first bottom metal layer on the substrate;
a first auxiliary layer directly on the first bottom metal layer;
a buffer layer covering the first bottom metal layer;
a first transistor on the buffer layer;
a light emitting element on the first transistor;
a first pixel electrode electrically connected to a first end of the light emitting element; and
a second pixel electrode electrically connected to a second end of the light emitting element,
wherein the first transistor comprises a first transistor electrode and a second transistor electrode, and
wherein the second pixel electrode is connected to the first bottom metal layer by the first auxiliary layer.

13. The display device according to claim 12, wherein the first auxiliary layer comprises indium tin oxide, ITO.

14. The display device according to claim 12 or 13, further comprising
a second bottom metal layer and a fourth bottom metal layer on the substrate;
a first alignment electrode under the first pixel electrode; and
a second alignment electrode under the second pixel electrode,
wherein one alignment electrode from among the first alignment electrode and the second alignment electrode is directly connected to one transistor electrode of the first transistor electrode and the second transistor electrode,
wherein the first transistor electrode is connected to the fourth bottom metal layer by a fourth auxiliary layer on the fourth bottom metal layer, and
wherein the second transistor electrode is electrically connected to the second bottom metal layer by a second auxiliary layer on the second bottom metal layer.

15. A display device comprising:
a substrate;
a first bottom metal layer on the substrate;
a first auxiliary layer directly on the first bottom metal layer;
a buffer layer covering the first bottom metal layer;
a first transistor on the buffer layer, and comprising a first transistor electrode and a second transistor electrode;
a light emitting element on the first transistor;
a first pixel electrode electrically connected to a first end of the light emitting element; and
a second pixel electrode electrically connected to a second end of the light emitting element,
wherein the second pixel electrode is connected to the first bottom metal layer by the first auxiliary layer, and
wherein the second pixel electrode directly contacts the first auxiliary layer.
